# EUROPEAN PATENT APPLICATION

(11) **EP 4 633 342 A1**
(43) Date of publication of application: **15.10.2025**
(21) Application number: 25169204.2
(22) Date of filing: 08.04.2025
(51) Int. Cl.: H10K 59/35

(54) **DISPLAY PANEL AND ELECTRONIC APPARATUS INCLUDING THE SAME**

(30) Priority: 09.04.2024 KR 20240048239; 01.07.2024 KR 20240086412
(71) Applicant: Samsung Display Co., Ltd., Yongin-si, Gyeonggi-do 17113 (KR)
(72) Inventor: Choi, Kyunghyun, Yongin-si, Gyeonggi-do 17113 (KR); Son, Donghyun, Yongin-si, Gyeonggi-do 17113 (KR); Lee, Sola, Yongin-si, Gyeonggi-do 17113 (KR); Kim, Jongseok, Yongin-si, Gyeonggi-do 17113 (KR)
(74) Representative: Gulde & Partner

(57) **Abstract**

In an embodiment, a display panel (10) includes a substrate (100) including a first display area (DA1) and a second display area (DA2) surrounded by the first display area (DA1), where the second display area (DA2) includes a transmissive area (TA) and a non-transmissive area (NTA), a first sub-pixel circuit group disposed in the first display area (DA1), a first light-emitting diode group (EDG1) disposed in the first display area (DA1) and electrically connected to the first sub-pixel circuit group, a second sub-pixel circuit group (PCG) disposed in the non-transmissive area (NTA), a second light-emitting diode group (EDG2) disposed in the non-transmissive area (NTA) and electrically connected to the second sub-pixel circuit group (PCG), and an auxiliary light-emitting diode (EDa) disposed inside the transmissive area (TA) and electrically connected to the second sub-pixel circuit group (PCG).

## Description

### BACKGROUND

### 1. Field

One or more embodiments relate to a display panel and an electronic apparatus including the display panel.

### 2. Description of the Related Art

In general, a display panel includes a display element and electronic components to control electrical signals to be applied to the display element. The electronic components typically include thin film transistors, capacitors, and wires.

Recently, uses of display panels have diversified. Furthermore, as display panels have become thinner and lighter, the range of use thereof has expanded. Accordingly, research on display panels to add functions other than image display to the inside of the display area is ongoing to increase the area occupied by a display area in a display panel and simultaneously add various functions.

### SUMMARY

One or more embodiments include a display panel in which a resolution of a component area is improved, and an electronic apparatus including the display panel.

According to one or more embodiments, a display panel includes a substrate including a first display area and a second display area surrounded by the first display area, where the second display area includes a transmissive area and a non-transmissive area, a first sub-pixel circuit group disposed in the first display area, a first light-emitting diode group disposed in the first display area and electrically connected to the first sub-pixel circuit group, a second sub-pixel circuit group disposed in the non-transmissive area, a second light-emitting diode group disposed in the non-transmissive area and electrically connected to the second sub-pixel circuit group, and an auxiliary light-emitting diode disposed inside the transmissive area and electrically connected to the second sub-pixel circuit group.

In an embodiment, the display panel may further include a lower metal layer disposed in the second display area and defining a first opening overlapping the transmissive area, where the lower metal layer may include a first island portion overlapping the auxiliary light-emitting diode and a bridge portion extending from the first island portion to the non-transmissive area.

In an embodiment, the first opening may have an oval shape or a capsule shape in a plan view, and at least a portion of a boundary of the first opening may be convex.

In an embodiment, the first opening may have a circular shape in a plan view, and the auxiliary light-emitting diode may overlap a center area of the first opening.

In an embodiment, the bridge portion may have an arc shape in a plan view.

In an embodiment, the bridge portion may have a first boundary and a second boundary, which are opposite to each other, where the first boundary may have a first radius of curvature and the second boundary may have a second radius of curvature greater than the first radius of curvature.

In an embodiment, the bridge portion may be provided in plural, and a plurality of bridge portions may have a same shape as each other in a plan view.

In an embodiment, the first opening may be provided in plural, a plurality of first openings may include a first first opening, a second first opening, a third first opening, and a fourth first opening which surround one point of the non-transmissive area, and a bridge portion of the first first opening, a bridge portion of the second first opening, a bridge portion of the third first opening, and a bridge portion of the fourth first opening may respectively have shapes of four arcs, which may be obtained by dividing an imaginary circle into four quarters.

In an embodiment, the second light-emitting diode group and the auxiliary light-emitting diode may be alternately arranged in a first direction and a second direction intersecting the first direction.

In an embodiment, the first light-emitting diode group may include a first red light-emitting diode and a first blue light-emitting diode arranged in an odd-numbered row, and a first green light-emitting diode arranged in an even-numbered row, and the second light-emitting diode group may include a second red light-emitting diode and a second blue light-emitting diode arranged in the odd-numbered row and a second green light-emitting diode arranged in the even-numbered row.

In an embodiment, the auxiliary light-emitting diode may be arranged in the even-numbered row.

In an embodiment, the auxiliary light-emitting diode may emit green light.

In an embodiment, the second green light-emitting diode and the auxiliary light-emitting diode may be alternately arranged in a first direction and a second direction intersecting the first direction, and may be spaced apart from each other at equal intervals.

In an embodiment, the display panel may further include an encapsulation layer disposed on the first light-emitting diode group, the second light-emitting diode group, and the auxiliary light-emitting diode, a light shielding layer may be disposed on the encapsulation layer and may define first filter openings overlapping the second light-emitting diode group and the second opening overlapping the transmissive area, first color filters may be disposed on the light shielding layer to correspond to the second light-emitting diode group, and a second color filter may be disposed on the encapsulation layer to correspond to the auxiliary light-emitting diode.

In an embodiment, the light shielding layer may further include a first portion disposed within the second opening, and the first portion may define the second filter opening overlapping the auxiliary light-emitting diode.

In an embodiment, the display panel may further include an encapsulation layer disposed on the first light-emitting diode group, the second light-emitting diode group, and the auxiliary light-emitting diode, a light shielding layer may be disposed on the encapsulation layer and may define first filter openings overlapping the second light-emitting diode group and a second filter opening overlapping the auxiliary light-emitting diode, first color filters may be disposed on the light shielding layer to correspond to the second light-emitting diode group, and a second color filter may be disposed on the light shielding layer to correspond to the auxiliary light-emitting diode.

In an embodiment, the display panel may further include an insulating layer between the second sub-pixel circuit group and the second light-emitting diode group, where the insulating layer may define an opening overlapping the transmissive area.

In an embodiment, the non-transmissive area may include a first area and a second area outside the first area, the second sub-pixel circuit group may be disposed in the first area, and the second light-emitting diode group may include second red light-emitting diodes and second blue light-emitting diodes disposed in the first area, and third green light-emitting diodes disposed in the second area.

In an embodiment, the second light-emitting diode group may further include a second green light-emitting diode disposed in the first area, and the third green light-emitting diode and the second green light-emitting diode may be electrically connected to a same sub-pixel circuit.

According to one or more embodiments, a display panel includes a substrate including a first display area and a second display area defined inside the first display area, where the second display area includes a transmissive area and a non-transmissive area outside the transmissive area, a first sub-pixel circuit group disposed in the first display area, a first light-emitting diode group arranged in the first display area and electrically connected to the first sub-pixel circuit group, a second sub-pixel circuit group disposed in the non-transmissive area, and a second light-emitting diode group arranged in the non-transmissive area and electrically connected to the second sub-pixel circuit group, where the non-transmissive area may include a first area and a second area outside the first area, the second sub-pixel circuit group may be disposed in the first area, and the second light-emitting diode group may include first second light-emitting diodes arranged in the first area and second second light-emitting diodes arranged in the second area.

In an embodiment, the transmissive area may be provided in plural, the first area may be surrounded by four transmissive areas, in a plan view, and the second second light-emitting diodes may be disposed one by one between two adjacent transmissive areas among the four transmissive areas.

In an embodiment, the first second light-emitting diodes may include at least one blue light-emitting diode and at least one red light-emitting diode, and the second second light-emitting diodes may comprise green light-emitting diodes.

In an embodiment, a pair of the second second light-emitting diodes adjacent to each other may be electrically connected to a same sub-pixel circuit.

In an embodiment, the first second light-emitting diodes may include at least one blue light-emitting diode, at least one red light-emitting diode, and a green light-emitting diode, and the second second light-emitting diodes may comprise green light-emitting diodes.

In an embodiment, the display panel may further include a lower metal layer arranged in the second display area and defining a first opening overlapping the transmissive area, where the first opening may have an oval shape or a capsule shape, in a plan view.

In an embodiment, at least a portion of a boundary of the first opening may be convex.

According to one or more embodiments, an electronic apparatus includes a display panel and a component overlapping the display panel, where the display panel includes a substrate including a first display area and a second display area surrounded by the first display area, where the second display area includes a transmissive area and a non-transmissive area, a first sub-pixel circuit group disposed in the first display area, a first light-emitting diode group disposed in the first display area and electrically connected to the first sub-pixel circuit group, a second sub-pixel circuit group disposed in the non-transmissive area, a second light-emitting diode group disposed in the non-transmissive area and electrically connected to the second sub-pixel circuit group, and an auxiliary light-emitting diode disposed inside the transmissive area and electrically connected to the second sub-pixel circuit group.

According to one or more embodiments, an electronic apparatus includes a display panel and a component overlapping the display panel, where the display panel includes a substrate including a first display area and a second display area defined inside the first display area, where the second display area includes a transmissive area and a non-transmissive area outside the transmissive area, a first sub-pixel circuit group disposed in the first display area, a first light-emitting diode group disposed in the first display area and electrically connected to the first sub-pixel circuit group, a second sub-pixel circuit group disposed in the non-transmissive area, and a second light-emitting diode group disposed in the non-transmissive area and electrically connected to the second sub-pixel circuit group, where the non-transmissive area includes a first area and a second area outside the first area, the second sub-pixel circuit group is disposed in the first area, and the second light-emitting diode group includes first second light-emitting diodes disposed in the first area and second second light-emitting diodes disposed in the second area.

A display panel and an electronic apparatus including the display panel according to embodiments as described herein may improve a resolution of a component area by arranging auxiliary pixels in a component area. The scope of the disclosure is not limited by the above effects.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other features of certain embodiments of the disclosure will be more apparent from the following description taken in conjunction with the accompanying drawings, in which:
FIG. 1 is a schematic perspective view of an electronic apparatus according to an embodiment;
FIG. 2 is a schematic cross-sectional view of the electronic apparatus of FIG. 1 taken along line I-I';
FIG. 3 is a schematic plan view of a display panel according to an embodiment;
FIGS. 4A and 4B are each an equivalent circuit diagram of one pixel according to an embodiment;
FIG. 5 is a schematic cross-sectional view of a display panel according to an embodiment;
FIG. 6 is a schematic plan view of a display panel according to an embodiment;
FIG. 7A is a schematic plan view of a display panel according to an embodiment;
FIG. 7B is a schematic plan view of a second lower metal layer according to an embodiment;
FIGS. 8A, 8B, and 8C are schematic cross-sectional views of the display panel of FIG. 7A taken along line II-II';
FIG. 9 is a schematic cross-sectional view of a display panel according to an embodiment;
FIG. 10 is a schematic plan view of a display panel according to an embodiment;
FIGS. 11A and 11B are each a view for explaining the arrangements of a bridge portion and an island portion according to an embodiment;
FIG. 12 is a view for explaining the shapes of the bridge portion and the island portion;
FIG. 13 is a schematic plan view of a display panel according to an embodiment;
FIG. 14 is a schematic plan view of a display panel according to an embodiment; and
FIG. 15 is a schematic plan view of a display panel according to an embodiment.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

Various modifications may be applied to the present embodiments, and particular embodiments will be illustrated in the drawings and described in the detailed description section. The effect and features of the present embodiments, and a method to achieve the same, will be clearer referring to the detailed descriptions below with the drawings. However, the present embodiments may be implemented in various forms, not by being limited to the embodiments presented below.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. Throughout the disclosure, the expression "at least one of a, b or c" or "at least one selected from a, b and c" indicates only a, only b, only c, both a and b, both a and c, both b and c, all of a, b, and c, or variations thereof. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

In the specification, it will be understood that when an element, such as a layer, a film, a region, or a plate, is referred to as being "on" another element, the element can be directly on the other element or intervening elements may be present thereon. In contrast, when an element is referred to as being "directly on" another element, there are no intervening elements present.

In the specification, it will be understood that when a layer, region, or element is referred to as being "connected to" another layer, region, or element, it can be directly connected to the other layer, region, or component or indirectly connected to the other layer, region, or component via intervening layers, regions, or components. For example, in the specification, when a layer, region, or component is referred to as being electrically connected to another layer, region, or component, it can be directly electrically connected to the other layer, region, or component or indirectly electrically connected to the other layer, region, or component via intervening layers, regions, or components.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

In the specification, the x-axis, the y-axis and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

In the specification, when it is referred to as "in a plan view," this means when an object part is viewed from above, and when it is referred to as "in a cross-sectional view," it means when an object part that is cut vertically is viewed from the side.

In the specification, when a first component is referred to as "overlapping" a second component, it means that the first component is disposed above or below the second component at least partially overlapping each other in a plan view.

In the specification, when a certain embodiment may be implemented differently, a specific process order may be performed differently from the described order. For example, two consecutively described processes may be performed substantially at the same time or performed in an order opposite to the described order.

Sizes of elements in the drawings may be exaggerated or reduced for convenience of explanation. For example, since sizes and thicknesses of elements in the drawings are arbitrarily illustrated for convenience of explanation, the following embodiments are not limited thereto.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the appended claims.

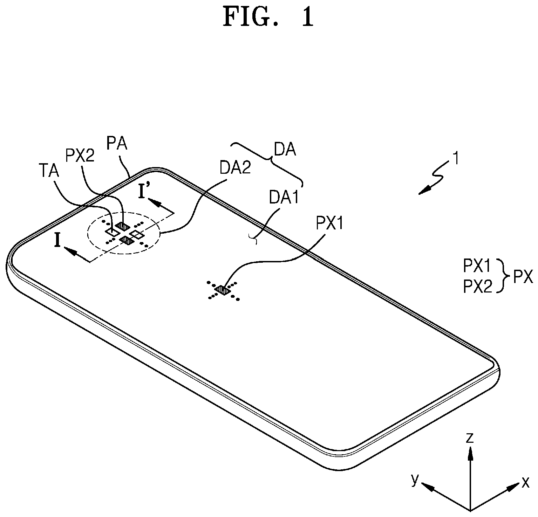

FIG. 1 is a schematic perspective view of an electronic apparatus 1 according to an embodiment.

Referring to FIG. 1, an embodiment of the electronic apparatus 1 may include a display area DA and a peripheral area PA outside the display area DA. The display area DA may include a first display area DA1 and a second display area DA2 that is at least partially surrounded by the first display area DA1. The display area DA may be an area where a plurality of pixels PX are arranged. The first display area DA1 and the second display area DA2 may each individually display an image or may display an image together. The peripheral area PA may be a kind of a non-display area where the pixels PX are not arranged. The display area DA may be entirely surrounded by the peripheral area PA.

The first display area DA1 may have an approximately rectangular shape in which, in a plan view (or when viewed in a third direction), the length in a first direction (x direction) is shorter than a length in a second direction (y direction). Here, the third direction (z direction) may be a direction perpendicular to the first direction (x direction) and the second direction (y direction) or a thickness direction of a display panel of the electronic apparatus 1. The first display area DA1 may have one of other various shapes, in a plan view, such as other polygonal shapes, a circular shape, an oval shape, an amorphous shape, etc. The second display area DA2 may have various shapes, in a plan view, such as a circular shape, an oval shape, a polygonal shape such as a quadrangular shape, an amorphous shape, etc. FIG. 1 illustrates an embodiment where the second display area DA2 is disposed in the upper center (the center in +y direction) of the first display area DA1, but not being limited thereto. In another embodiment, the second display area DA2 may be disposed in the lower center (the center in -y direction), the upper left, the upper right, the lower left, or the lower right of the first display area DA1.

The electronic apparatus 1 may provide an image using the pixels PX disposed in the display area DA. Each of the pixels PX may include a display element and sub-pixel circuits electrically connected to the display element. The display element may be an organic light-emitting diode that emits red, green, or blue light. The pixels PX may include a plurality of first pixels PX1 disposed in the first display area DA1 and a plurality of second pixels PX2 disposed in the second display area DA2. In the disclosure, a pixel PX may refer to a sub-pixel that emits a different color of light, and each pixel PX may be, for example, one of a red sub-pixel, a green sub-pixel, and a blue sub-pixel.

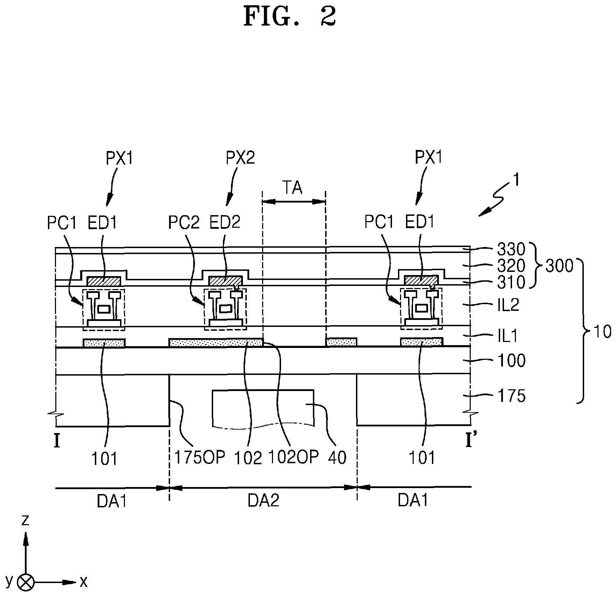

The electronic apparatus 1 may include a component 40 (see FIG. 2) that is disposed under a display panel overlapping the second display area DA2. The second display area DA2 may include a plurality of transmissive areas TA that transmit light or sound emitted from the component 40 or traveling toward the component 40. When the second display area DA2 transmits light, the light transmittance of the second display area DA2 may be about 30% or greater, about 50% or greater, about 75% or greater, about 80% or greater, about 85% or greater, or about 90% or greater.

As the second display area DA2 includes the transmissive areas TA, the number of second pixels PX2 per unit area in the second display area DA2 may be less than the number of first pixels PX1 per unit area in the first display area DA1. Accordingly, the resolution of the second display area DA2 may be less than the resolution of the first display area DA1.

Although FIG. 1 illustrates an embodiment where a single second display area DA2 is defined and located within the first display area DA1, the disclosure is not limited thereto. In another embodiment, the electronic apparatus 1 may include a plurality of second display areas DA2, and the shapes and sizes of the second display areas DA2 may be different from each other.

The electronic apparatus 1 is a device for displaying a video or a still image, and may be used as display screens for various products including a portable electronic apparatus, such as a mobile phone, a smartphone, a tablet personal computer (PC), a mobile communication terminal, an electronic organizer, an electronic book, a portable multimedia player (PMP), a navigation device, or an ultra-mobile PC (UMPC), as well as a television, a notebook computer, a monitor, a billboard, or an Internet of Things (IoT) device. Furthermore, the electronic apparatus 1 according to an embodiment may be used for a wearable device, such as a smart watch, a watch phone, a glasses type display, or a head mounted display (HMD). Furthermore, the electronic apparatus 1 according to an embodiment may be used as an instrument panel of a vehicle, a center information display (CID) disposed in the center fascia or dashboard of a vehicle, a room mirror display in lieu of a side mirror of a vehicle, or a display screen disposed at the rear surface of a front seat as an entertainment device for a rear seat of a vehicle.

FIG. 2 is a schematic cross-sectional view of the electronic apparatus of FIG. 1 taken along line I-I'.

Referring to FIG. 2, an embodiment of the electronic apparatus 1 may include a display panel 10 and the component 40 overlapping the display panel 10. The display panel 10 may include a substrate 100, a first insulating layer IL1, a second insulating layer IL2, a first pixel PX1, a second pixel PX2, an encapsulation layer 300, and a protective film 175.

The substrate 100 may include glass or polymer resin. The polymer resin may include polyethersulfone, polyacrylate, polyetherimide, polyethylene naphthalate, polyethylene terephthalate, polyphenylene sulfide, polyarylate, polyimide, polycarbonate, or cellulose acetate propionate. The substrate 100 including polymer resin may be flexible, rollable or bendable. In an embodiment, the substrate 100 may have a multilayer structure including a layer including the polymer resin described above and a layer including an inorganic material, i.e., an inorganic layer (not shown).

The display panel 10 may include the first display area DA1 in which the first pixels PX1 are arranged and the second display area DA2 in which the second pixels PX2 are arranged. In such an embodiment, as the elements of the display panel 10 is disposed on the front or rear surface of the substrate 100, it may be understood that the substrate 100 includes the first display area DA1 and the second display area DA2. The second display area DA2 may include at least one transmissive area TA through which light or sound passes.

The first insulating layer IL1, the second insulating layer IL2, the first pixel PX1, the second pixel PX2, and the encapsulation layer 300 may be disposed on the front surface of the substrate 100, and the protective film 175 may be disposed on the rear surface of the substrate 100. The first pixel PX1 may include a first sub-pixel circuit PC1 and a first light-emitting diode ED1 electrically connected to the first sub-pixel circuit PC1, and the second pixel PX2 may include a second sub-pixel circuit PC2 and a second light-emitting diode ED2 electrically connected to the second sub-pixel circuit PC2.

The protective film 175 may be attached to the rear surface of the substrate 100. An adhesive layer may be provided between the protective film 175 and the substrate 100. Alternatively, the protective film 175 may be directly formed on the rear surface of the substrate 100. In such an embodiment, no adhesive layer is provided between the protective film 175 and the substrate 100.

The protective film 175 may support and protect the substrate 100. The protective film 175 may be provided with an opening 175OP overlapping the second display area DA2. As the opening 175OP is defined or formed through the protective film 175, the transmittance of the second display area DA2, for example, the light transmittance of the transmissive area TA, may be improved. The protective film 175 may include an organic insulating material, such as polyethylene terephthalate (PET) or polyimide (PI).

The first insulating layer IL1 may be disposed on the substrate 100. The first insulating layer IL1 may be a buffer layer to effectively prevent or substantially reduce infiltration of impurities into the first sub-pixel circuit PC1 and the second sub-pixel circuit PC2 from the substrate 100.

The first sub-pixel circuit PC1 and the second sub-pixel circuit PC2 may be disposed on the first insulating layer IL1. The first sub-pixel circuit PC1 may be disposed in the first display area DA1. The second sub-pixel circuit PC2 may be disposed in the second display area DA2, in particular in a non-transmissive area outside the transmissive area TA. The first sub-pixel circuit PC1 and the second sub-pixel circuit PC2 may each include at least one thin film transistor.

A first lower metal layer 101 may be disposed under the first sub-pixel circuit PC1, for example, between the substrate 100 and the first insulating layer IL1, to overlap the first sub-pixel circuit PC1. A second lower metal layer 102 may be disposed under the second sub-pixel circuit PC2, for example, between the substrate 100 and the first insulating layer IL1, to overlap the second sub-pixel circuit PC2. The second lower metal layer 102 may cover the second display area DA2 and be provided with at least one first opening 102OP through which light or sound emitted from the component 40 or traveling toward the component 40 passes.

The first opening 102OP of the second lower metal layer 102 may overlap the transmissive area TA. In a plan view, the boundary of the first opening 102OP may coincide with (or correspond to) the boundary of the transmissive area TA. In other words, the first opening 102OP may define the transmissive area TA. A certain voltage may be applied to the second lower metal layer 102. When a certain voltage is applied to the second lower metal layer 102, the deterioration of the thin film transistor of the second sub-pixel circuit PC2 may be effectively prevented or substantially reduced.

The second insulating layer IL2 may be disposed between components of the first sub-pixel circuit PC1 and the second sub-pixel circuit PC2. The first light-emitting diode ED1 and the second light-emitting diode ED2 may be disposed on the second insulating layer IL2. The first light-emitting diode ED1 and the second light-emitting diode ED2 may each be a display element and may emit red, green, or blue light. The first light-emitting diode ED1 and the second light-emitting diode ED2 may each include an organic light-emitting diode or an inorganic light-emitting diode (micro LED).

The first light-emitting diode ED1 may be disposed in the first display area DA1. The second light-emitting diode ED2 may be disposed in the second display area DA2, e.g., in a non-transmissive area in the second display area DA2 outside the transmissive area TA. The first light-emitting diode ED1 may be electrically connected to the first sub-pixel circuit PC1, and the second light-emitting diode ED2 may be electrically connected to the second sub-pixel circuit PC2.

The first light-emitting diode ED1 and the second light-emitting diode ED2 may be sealed with an encapsulation member. The encapsulation member may include the encapsulation layer 300. The encapsulation layer 300 may include at least one inorganic encapsulation layer and at least one organic encapsulation layer. In an embodiment, the encapsulation layer 300 may include a first inorganic encapsulation layer 310, a second inorganic encapsulation layer 330, and an organic encapsulation layer 320 between the first inorganic encapsulation layer 310 and the second inorganic encapsulation layer 330. The first inorganic encapsulation layer 310 and the second inorganic encapsulation layer 330 may each include an inorganic insulating material, such as silicon oxide, silicon nitride, or silicon oxynitride. The organic encapsulation layer 320 may include a polymer-based material. The polymer-based material may include at least one selected from acrylic resin, epoxy-based resin, polyimide, and polyethylene. In another embodiment, the encapsulation member may include an encapsulation substrate.

In an embodiment, the display panel 10 may further include a black matrix (not shown) and a color filter layer (not shown) including color filters. The color filter layer may be disposed on the encapsulation layer 300.

The second display area DA2 may include the transmissive area TA in which no thin film transistor is arranged. The transmissive area TA may be understood as an area through which light or sound emitted from the component 40 or traveling toward the component 40 passes.

As the second display area DA2 includes a plurality of transmissive areas TA, the resolution of the second display area DA2 may be less than the resolution of the first display area DA1. In an embodiment, for example, the resolution of the second display area DA2 may be about 1/2, 1/3, 1/4, 1/5.33, 1/8, 3/8, 1/9, 1/12.25, or 1/16 of the resolution of the first display area DA1.

The component 40 may be an electronic element using light or sound. In an embodiment, for example, the electronic element may be a sensor to measure a distance, such as a proximity sensor, a sensor to recognize a portion (e.g., a fingerprint, an iris, a face, etc.) of a user's body, an image sensor (e.g., a camera) to capture an image, or a small lamp to output light. The electronic element using light may use light of various wavelength bands, such as visible light, infrared light, and ultraviolet light. The electronic element using sound may use ultrasound or sound of a different frequency band.

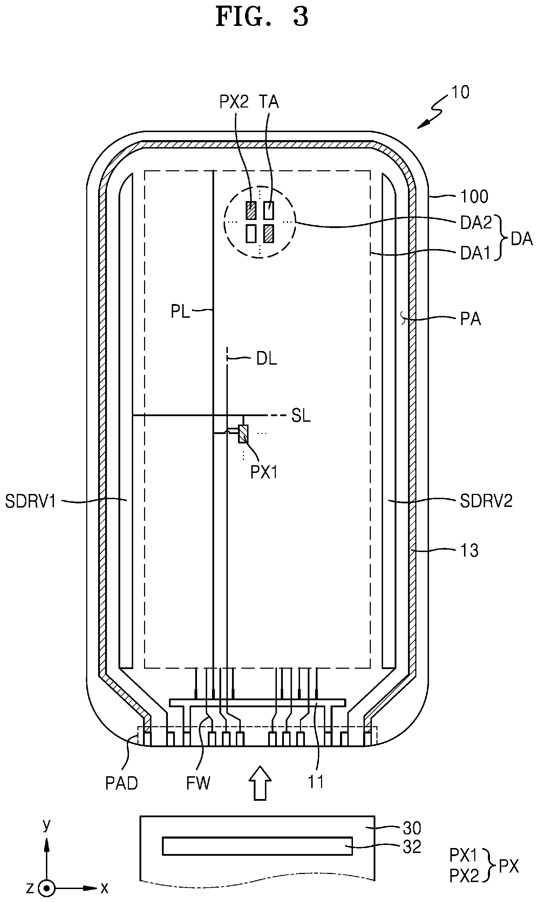

FIG. 3 is a schematic plan view of the display panel 10 according to an embodiment.

Referring to FIG. 3, an embodiment of the display panel 10 may include the display area DA in which the pixels PX are arranged and the peripheral area PA outside the display area DA. The display area DA may include the first display area DA1 in which a main image is displayed, and the second display area DA2 having the transmissive areas TA and in which an auxiliary image is displayed. The auxiliary image may form one full image with the main image, and the auxiliary image may be an image independent from the main image. Hereinafter, in the specification, the substrate 100 may be understood as including the areas of the first display area DA1, the second display area DA2, and the peripheral area PA.

The pixel PX may include the first pixels PX1 and the second pixels PX2. The first pixels PX1 may be disposed in the first display area DA1, and the second pixels PX2 may be disposed in the second display area DA2. The first pixel PX1 and the second pixel PX2 may include the display elements that emit red, green, or blue light.

The second display area DA2 may be disposed in the first display area DA1. In other words, the second display area DA2 may be surrounded by the first display area DA1. Although FIG. 3 illustrate an embodiment in which only one second display area DA2 is defined, the second display area DA2 may include a plurality of second display areas. The shapes and sizes of the second display areas DA2 may be different from each other.

The pixels PX may each include a sub-pixel circuit electrically connected to the display element. Each of sub-pixel circuits may be electrically connected to outer circuits and wires arranged in the peripheral area PA. A first drive circuit SDRV1, a second drive circuit SDRV2, pads PAD, a driving voltage supply line 11, and a common voltage supply line 13 may be disposed in the peripheral area PA.

The first drive circuit SDRV1 and the second drive circuit SDRV2 may be disposed parallel to each other with the display area DA therebetween. The pixels PX arranged in the display area DA may be electrically connected to the first drive circuit SDRV1 or the second drive circuit SDRV2 through scan lines SL extending in a first direction (x direction). In an embodiment, for example, some of the pixels PX may be electrically connected to the first drive circuit SDRV1, and the others may be electrically connected to the second drive circuit SDRV2. The first drive circuit SDRV1 and the second drive circuit SDRV2 may each sequentially transmit, through the scan line SL, scan signals to the pixels PX located in a same row as the scan line SL. In another embodiment, one of the first drive circuit SDRV1 and the second drive circuit SDRV2 may be omitted.

Although FIG. 3 illustrates that one scan line SL is connected to one pixel PX for convenience of illustration, the disclosure is not limited thereto. In an embodiment, one pixel PX may be connected to the scan lines SL, and the scan lines SL may be configured to transmit different scan signals, for example, gate signals and an emission control signal.

The pads PAD may be disposed on one side of the substrate 100. The pads PAD may be exposed without being covered by an insulating layer and may be connected to a circuit board 30. A display drive circuit 32 may be disposed on the circuit board 30.

The display drive circuit 32 may generate a control signal that is transmitted to the first drive circuit SDRV1 and the second drive circuit SDRV2. The display drive circuit 32 may include a data drive circuit, and the data drive circuit may generate a data signal. The generated data signal may be transmitted to the pixels PX through a fan-out wire FW arranged in the peripheral area PA of the display panel 10, and a data line DL connected to the fan-out wire FW and extending in a second direction (y direction). In an embodiment, the data drive circuit may be disposed in the peripheral area PA of the substrate 100.

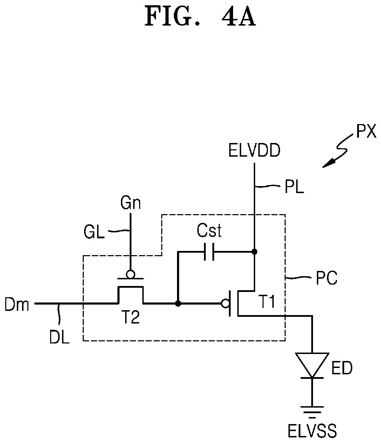

The display drive circuit 32 may supply a driving voltage ELVDD (see FIG. 4A) to the driving voltage supply line 11, and supply a common voltage ELVSS (see FIG. 4A) to the common voltage supply line 13. The driving voltage ELVDD may be applied to the pixels PX through a driving voltage line PL connected to the driving voltage supply line 11 and extending toward the transmissive area TA, and the common voltage ELVSS may be applied to a counter electrode of a light-emitting diode through the common voltage supply line 13.

The driving voltage supply line 11 may extend in the first direction (x direction) on the lower side of the peripheral area PA. The common voltage supply line 13 may partially surround the first display area DA1, in a plan view. The common voltage supply line 13 may have a loop shape with one open side.

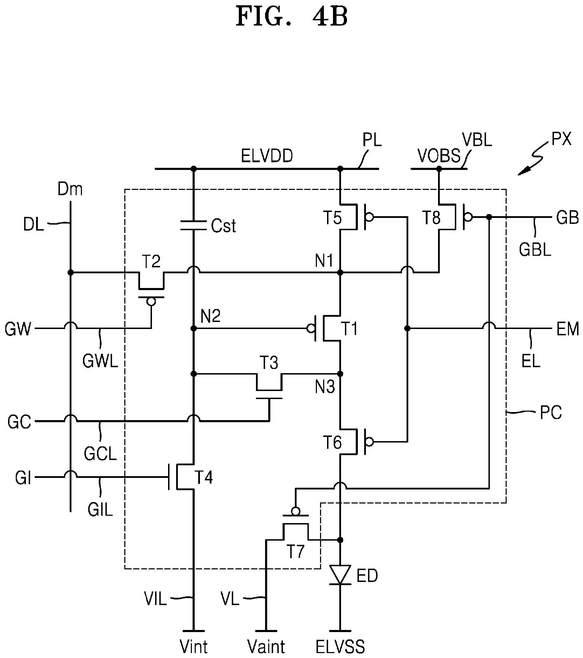

FIGS. 4A and 4B are each an equivalent circuit diagram of one pixel according to an embodiment.

Referring to FIG. 4A, in an embodiment, the pixel PX may include a sub-pixel circuit PC and a light-emitting diode ED electrically connected to the sub-pixel circuit PC. The sub-pixel circuit PC may include a first transistor T1, a second transistor T2, and a capacitor Cst. The sub-pixel circuit PC may be electrically connected to a gate line GL and the data line DL. The first transistor T1 may be a driving transistor, and the second transistor T2 may be a switching transistor. The second transistor T2 may be electrically connected to the gate line GL and the data line DL, and may transmit a data signal Dm input through the data line DL to the first transistor T1 in response to a gate signal Gn input through the gate line GL.

The capacitor Cst may be connected to the second transistor T2 and the driving voltage line PL, and may store a voltage corresponding to a difference between a voltage received from the second transistor T2 and the driving voltage ELVDD supplied to the driving voltage line PL.

The first transistor T1 may be connected to the driving voltage line PL and the capacitor Cst, and may control a driving current flowing from the driving voltage line PL to the light-emitting diode ED corresponding to a value of the voltage stored in the capacitor Cst. The light-emitting diode ED may emit light having a certain luminance by the driving current.

In an embodiment, the sub-pixel circuit PC may include two transistors and one capacitor as shown in FIG. 4A, but the disclosure is not limited thereto. In another embodiment, the sub-pixel circuit PC may include three or more transistors and/or two or more capacitors.

Referring to FIG. 4B, in an embodiment, the sub-pixel circuit PC may include first to eighth transistors T1, T2, T3, T4, T5, T6, T7, and T8 and the capacitor Cst. The sub-pixel circuit PC may be electrically connected to the data line DL, a first gate line GWL, a second gate line GIL, a third gate line GCL, a fourth gate line GBL, and an emission control line EL. Furthermore, the sub-pixel circuit PC may be electrically connected to an initialization voltage line VL, a node initialization voltage line VIL, and the driving voltage line PL.

In an embodiment, at least one of the first to eighth transistors T1 to T8 may be provided as n-channel metal-oxide-semiconductor field-effect transistors (MOSFETs) (NMOS), and the others of the first to eighth transistors T1 to T8 may be provided as p-channel MOSFETs (PMOS). FIG. 4B illustrates an embodiment where, among the first to eighth transistors T1 to T8, the third transistor T3 and the fourth transistor T4 are provided as NMOS, and the other transistors T1, T2, T5, T6, T7, and T8 are provided as PMOS. However, the disclosure is not limited thereto. In another embodiment, the first to eighth transistors T1 to T8 may be all provided as PMOS or NMOS. According to the type and/or operation condition of a transistor, a first terminal of the transistor may be a source electrode or a drain electrode, and a second terminal thereof may be an electrode different from the first terminal. In an embodiment, for example, the first terminal is a source electrode, and the second terminal may be a drain electrode.

The first transistor T1 (driving transistor) may be connected between the driving voltage line PL and the light-emitting diode ED. The first transistor T1 may be connected between a first node N1 and a third node N3. The first transistor T1 may include a gate electrode connected to a second node N2, a first terminal connected to the first node N1, and a second terminal connected to the third node N3. The driving voltage line PL may transmit the driving voltage ELVDD to the first transistor T1. The first transistor T1 may be a driving transistor, may receive the data signal Dm according to a switching operation of the second transistor T2, and may supply a driving current of the light-emitting diode ED.

The second transistor (data write transistor) T2 may be connected between the data line DL and the first node N1. The second transistor T2 may include a gate electrode connected to the first gate line GWL, a first terminal connected to the data line DL, and a second terminal connected to the first node N1. The second transistor T2 may be turned on by a first scan signal GW received through the first gate line GWL and may perform a switching operation to transmit the data signal Dm transmitted through the data line DL to the first node N1.

The third transistor (compensation transistor) T3 may be connected between the second node N2 and the third node N3. The third transistor T3 may include a gate electrode connected to the third gate line GCL, a first terminal connected to the second node N2, and a second terminal connected to the third node N3. The third transistor T3 may be turned on by a third scan signal GC received through the third gate line GCL to have the first transistor T1 diode-connected such that the threshold voltage of the first transistor T1 may be compensated.

The fourth transistor (node initialization transistor) T4 may be connected between the second node N2 and the node initialization voltage line VIL. The fourth transistor T4 may include a gate electrode connected to the second gate line GIL, a first terminal connected to the second node N2, and a second terminal connected to the node initialization voltage line VIL. The fourth transistor T4 may be turned on by a second scan signal GI received through the second gate line GIL and may transmit a node initialization voltage Vint to the gate electrode of the first transistor T1 to initialize the gate electrode of the first transistor T1.

The fifth transistor (first emission control transistor) T5 may be connected between the driving voltage line PL and the first node N1. The fifth transistor T5 may include a gate electrode connected to the emission control line EL, a first terminal connected to the driving voltage line PL, and a second terminal connected to the first node N1.

The sixth transistor (second emission control transistor) T6 may be connected between the light-emitting diode ED and the third node N3. The sixth transistor T6 may include a gate electrode connected to the emission control line EL, a first terminal connected to the third node N3, and a second terminal connected to the pixel electrode of the light-emitting diode ED. As the fifth transistor T5 and the sixth transistor T6 simultaneously turned on by an emission control signal EM received through the emission control line EL, a driving current may flow in the light-emitting diode ED.

The seventh transistor (initialization transistor) T7 may be connected between the light-emitting diode ED and the initialization voltage line VL. The seventh transistor T7 may include a gate electrode connected to the fourth gate line GBL, a first terminal connected to the second terminal of the sixth transistor T6 and the pixel electrode of the light-emitting diode ED, and a second terminal connected to the initialization voltage line VL. The seventh transistor T7 may be turned on by a fourth scan signal GB received through the fourth gate line GBL and may transmit an initialization voltage Vaint to the pixel electrode of the light-emitting diode ED to initialize the pixel electrode of the light-emitting diode ED. The seventh transistor T7 and the eighth transistor T8 may be simultaneously turned on by the fourth scan signal GB.

The eighth transistor (bias transistor) T8 may be connected between the first node N1 and a bias voltage line VBL. The eighth transistor T8 may include a gate electrode connected to the fourth gate line GBL, a first terminal connected to the bias voltage line VBL, and a second terminal connected to the first node N1. The eighth transistor T8 may be turned on by the fourth scan signal GB received through the fourth gate line GBL and may apply a bias voltage VOBS to the first terminal of the first transistor T1 to preset, in the first terminal, a voltage suitable for a subsequent operation of the first transistor T1.

The capacitor Cst may include a first capacitor electrode connected to the gate electrode of the first transistor T1 and a second capacitor electrode connected to the driving voltage line PL. The capacitor Cst may maintain a voltage applied to the gate electrode of the first transistor T1 by storing and maintaining a voltage corresponding to a difference in voltage between both ends of the driving voltage line PL and the gate electrode of the first transistor T1.

The light-emitting diode ED may include a pixel electrode and a counter electrode, and the counter electrode may receive the common voltage ELVSS. The light-emitting diode ED may receive a driving current from the first transistor T1 and emit light, thereby displaying an image.

Although FIG. 4B illustrates an embodiment where the sub-pixel circuit PC includes eight transistors and one capacitor, the disclosure is not limited thereto. The numbers of transistors and capacitors included in the sub-pixel circuit PC, and the circuit design may be variously changed.

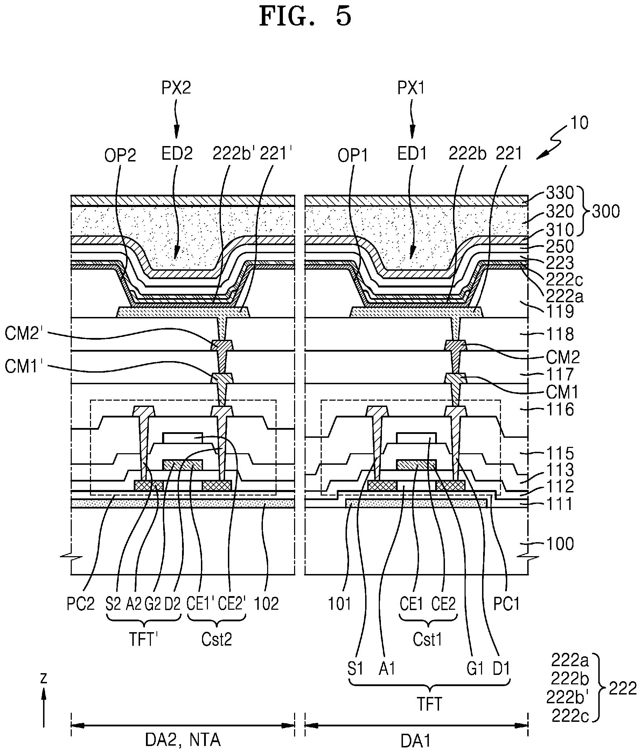

FIG. 5 is a schematic cross-sectional view of the display panel 10 according to an embodiment.

FIG. 5 schematically illustrates a portion of the second display area DA2 and a portion of the first display area DA1 of the display panel 10, to describe the second pixel PX2 arranged in the second display area DA2 and the first pixel PX1 arranged in the first display area DA1.

Referring to FIG. 5, in an embodiment, the first pixel PX1 may be arranged in the first display area DA1, and the second pixel PX2 may be arranged in the second display area DA2. The first pixel PX1 may include the first light-emitting diode ED1 arranged in the first display area DA1 and the first sub-pixel circuit PC1 electrically connected to the first light-emitting diode ED1. The second pixel PX2 may include the second light-emitting diode ED2 arranged in the second display area DA2 and the second sub-pixel circuit PC2 electrically connected to the second light-emitting diode ED2. In the second display area DA2, an area in which the second pixel PX2 is arranged may be represented as a non-transmissive area NTA outside the transmissive areas TA (see FIG. 1). In an embodiment, for example, each of the transmissive areas TA may be surrounded by the non-transmissive area NTA.

A buffer layer 111 may be disposed on the substrate 100. The buffer layer 111 may be an element corresponding to the first insulating layer IL1 described above with reference to FIG. 2. The first sub-pixel circuit PC1 and the second sub-pixel circuit PC2 may be disposed on the buffer layer 111. The first sub-pixel circuit PC1 may be disposed in the first display area DA1, and the second sub-pixel circuit PC2 may be disposed in the second display area DA2. The first sub-pixel circuit PC1 may include a first thin film transistor TFT and a first storage capacitor Cst1. The second sub-pixel circuit PC2 may include a second thin film transistor TFT' and a second storage capacitor Cst2.

The first lower metal layer 101 may be disposed under the first sub-pixel circuit PC1 to overlap the first thin film transistor TFT, and the second lower metal layer 102 may be disposed under the second sub-pixel circuit PC2 to overlap the second thin film transistor TFT'. In an embodiment, for example, the first lower metal layer 101 and the second lower metal layer 102 may be disposed between the substrate 100 and the buffer layer 111. The first lower metal layer 101 and the second lower metal layer 102 may each include a conductive material, such as molybdenum (Mo), aluminum (Al), copper (Cu), or titanium (Ti), and may each be formed in a single layer or a multilayer (i.e., have a single layer structure or a multilayer structure).

The first lower metal layer 101 may reduce the deterioration of the first thin film transistor TFT. In some embodiments, the first lower metal layer 101 may be omitted. The second lower metal layer 102 may cover the entire surface of the substrate 100 in the non-transmissive area NTA. The second lower metal layer 102 may include a first opening 102OP (see FIG. 2) overlapping the transmissive area TA. The second lower metal layer 102 may reduce the deterioration of the second thin film transistor TFT' and prevent the diffraction of light through a gap between the components of the second sub-pixel circuit PC2.

The first thin film transistor TFT may include a first semiconductor layer A1, a first gate electrode G1, a first source electrode S1, and a first drain electrode D1. The second thin film transistor TFT' may include a second semiconductor layer A2, a second gate electrode G2, a second source electrode S2, and a second drain electrode D2.

The first semiconductor layer A1 and the second semiconductor layer A2 may be disposed on the buffer layer 111. The first semiconductor layer A1 and the second semiconductor layer A2 may each include a silicon-based semiconductor material. The silicon-based semiconductor material may include polysilicon or amorphous silicon. In another embodiment, the first semiconductor layer A1 and the second semiconductor layer A2 may each include an oxide-based semiconductor material. The oxide-based semiconductor material may include an oxide of at least one material selected from indium (In), gallium (Ga), stannum (Sn), zirconium (Zr), vanadium (V), hafnium (Hf), cadmium (Cd), germanium (Ge), chromium (Cr), Ti, and zinc (Zn). The first semiconductor layer A1 and the second semiconductor layer A2 may each include a channel region, and a source region and a drain region which are doped with impurities.

A first gate insulating layer 112 may be provided to cover the first semiconductor layer A1 and the second semiconductor layer A2. The first gate insulating layer 112 may include an inorganic insulating material, such as silicon oxide, silicon nitride, or silicon oxynitride. The first gate insulating layer 112 may be a single layer or multilayer, each layer therein including at least one selected from the inorganic insulating materials described above.

The first gate electrode G1 overlapping the first semiconductor layer A1 and the second gate electrode G2 overlapping the second semiconductor layer A2 may be disposed on the first gate insulating layer 112. The first gate electrode G1 and the second gate electrode G2 may each include Mo, Al, Cu, or Ti and may each be formed in a single layer or a multilayer. In an embodiment, the first gate electrode G1 and the second gate electrode G2 may each be a single layer including Mo.

A second gate insulating layer 113 may be disposed on the first gate electrode G1 and the second gate electrode G2. The second gate insulating layer 113 may include an inorganic insulating material, such as silicon oxide, silicon nitride, or silicon oxynitride. The second gate insulating layer 113 may be a single layer or multilayer, each layer therein including at least one selected from the inorganic insulating materials described above.

An upper capacitor electrode CE2 of the first storage capacitor Cst1 and an upper capacitor electrode CE2' of the second storage capacitor Cst2 may be disposed on the second gate insulating layer 113. The upper capacitor electrode CE2 of the first storage capacitor Cst1 may overlap the first gate electrode G1. The first gate electrode G1 may be provided or formed integrally with a lower capacitor electrode CE1 of the first storage capacitor Cst1 as a single unitary indivisible part. The upper capacitor electrode CE2' of the second storage capacitor Cst2 may overlap the second gate electrode G2. The second gate electrode G2 may be provided or formed integrally with a lower capacitor electrode CE1' of the second storage capacitor Cst2 as a single unitary indivisible part.

The upper capacitor electrode CE2 of the first storage capacitor Cst1 and the upper capacitor electrode CE2' of the second storage capacitor Cst2 may each include a conductive material, such as Mo, Al, Cu, or Ti and may each be formed in a single layer or a multilayer.

An interlayer insulating layer 115 may cover the upper capacitor electrode CE2 of the first storage capacitor Cst1 and the upper capacitor electrode CE2' of the second storage capacitor Cst2. The interlayer insulating layer 115 may include an inorganic insulating material, such as silicon oxide, silicon nitride, or silicon oxynitride. The interlayer insulating layer 115 may be a single layer or multilayer, each layer therein including at least one selected from the inorganic insulating materials described above.

The first source electrode S1 and the first drain electrode D1 of the first thin film transistor TFT and the second source electrode S2 and the second drain electrode D2 of the second thin film transistor TFT' may be disposed on the interlayer insulating layer 115. The first source electrode S1 and the first drain electrode D1 of the first thin film transistor TFT and the second source electrode S2 and the second drain electrode D2 of the second thin film transistor TFT' may each include a conductive material, such as Mo, Al, Cu, or Ti and may be provided in a single layer or a multilayer. In an embodiment, the first source electrode S1 and the first drain electrode D1 of the first thin film transistor TFT and the second source electrode S2 and the second drain electrode D2 of the second thin film transistor TFT' may have a multilayer structure of Ti/Al/Ti.

A first planarization layer 116, a second planarization layer 117, and a third planarization layer 118 may be disposed on the first source electrode S1 and the first drain electrode D1 of the first thin film transistor TFT and the second source electrode S2 and the second drain electrode D2 of the second thin film transistor TFT'. The first planarization layer 116, the second planarization layer 117, and the third planarization layer 118 may each include an organic insulating material or an inorganic insulating material and may each be provided in a single layer or a multilayer. The organic insulating material may include a general purpose polymer, such as benzocyclobutene (BCB), polyimide, hexamethyldisiloxane (HMDSO), polymethylmethacrylate (PMMA), or polystyrene (PS), a polymer derivative having a phenolic group, an acrylic polymer, an imide-based polymer, an aryl ether-based polymer, an amide-based polymer, a fluorine-based polymer, a p-xylene-based polymer, a vinyl alcohol-based polymer, and blends thereof. The inorganic insulating material may include silicon oxide, silicon nitride, or silicon oxynitride. After forming the first planarization layer 116, the second planarization layer 117, and the third planarization layer 118, chemical mechanical polishing may be performed to provide a flat upper surface. In some embodiments, some of the first planarization layer 116, the second planarization layer 117, and the third planarization layer 118 may be omitted.

The first light-emitting diode ED1 and the second light-emitting diode ED2 may be disposed on the third planarization layer 118. The first light-emitting diode ED1 may include a pixel electrode 221, a counter electrode 223, and an intermediate layer 222 between the pixel electrode 221 and the counter electrode 223. The second light-emitting diode ED2 may include a pixel electrode 221', the counter electrode 223, and the intermediate layer 222 between the pixel electrode 221' and the counter electrode 223.

The pixel electrode 221 of the first light-emitting diode ED1 and the pixel electrode 221' of the second light-emitting diode ED2 may be disposed on the third planarization layer 118. The pixel electrode 221 of the first light-emitting diode ED1 may be electrically connected to the first sub-pixel circuit PC1 through a first contact electrode CM1 between the first planarization layer 116 and the second planarization layer 117 and a second contact electrode CM2 between the second planarization layer 117 and the third planarization layer 118.

The pixel electrode 221' of the second light-emitting diode ED2 may be electrically connected to the second sub-pixel circuit PC2 through a first contact electrode CM1' between the first planarization layer 116 and the second planarization layer 117 and a second contact electrode CM2' between the second planarization layer 117 and the third planarization layer 118.

The pixel electrode 221 of the first light-emitting diode ED1 and the pixel electrode 221' of the second light-emitting diode ED2 may each include a conductive oxide, such as indium tin oxide, indium zinc oxide, zinc oxide (ZnO), indium oxide (In₂O₃), indium gallium oxide, or aluminum zinc oxide. The pixel electrode 221 of the first light-emitting diode ED1 and the pixel electrode 221' of the second light-emitting diode ED2 may each include a reflective film including silver (Ag), magnesium (Mg), Al, platinum (Pt), palladium (Pd), gold (Au), nickel (Ni), neodymium (Nd), iridium (Ir), Cr, or compounds thereof. The pixel electrode 221 of the first light-emitting diode ED1 and the pixel electrode 221' of the second light-emitting diode ED2 may each further include a film formed of ITO, IZO, ZnO, or In₂O₃ above/under the reflective film described above. In an embodiment, the pixel electrode 221 of the first light-emitting diode ED1 and the pixel electrode 221' of the second light-emitting diode ED2 may each have a multilayer structure of ITO/Ag/ITO.

A bank layer 119 may cover an edge of each of the pixel electrode 221 of the first light-emitting diode ED1 and the pixel electrode 221' of the second light-emitting diode ED2. The bank layer 119 may define a first pixel opening OP1 for exposing a center area of the pixel electrode 221 of the first light-emitting diode ED1 and a second pixel opening OP2 for exposing a center area of the pixel electrode 221' of the second light-emitting diode ED2. The first pixel opening OP1 may define an emission area of the first light-emitting diode ED1, and the second pixel opening OP2 may define an emission area of the second light-emitting diode ED2.

The bank layer 119 may effectively prevent the occurrence (or formation) of arc in the edge of each of the pixel electrodes 221 and 221' by increasing a distance between the edge of each of the pixel electrodes 221 and 221' and the counter electrode 223. The bank layer 119 may include an organic insulating material, such as polyimide, polyamide, acryl resin, benzocyclobutene, HMDSO, or phenol resin.

The intermediate layer 222 may be disposed on the bank layer 119. The intermediate layer 222 may include an emission layer 222b of the first light-emitting diode ED1 and an emission layer 222b' of the second light-emitting diode ED2. The emission layer 222b of the first light-emitting diode ED1 may be disposed to overlap the pixel electrode 221 of the first light-emitting diode ED1 through the first pixel opening OP1, and the emission layer 222b' of the second light-emitting diode ED2 may be disposed to overlap the pixel electrode 221' of the second light-emitting diode ED2 through the second pixel opening OP2. The emission layer 222b of the first light-emitting diode ED1 and the emission layer 222b' of the second light-emitting diode ED2 may each include a polymer or a low molecular weight organic material which emits a certain color (red, green, or blue) of light. The emission layer 222b of the first light-emitting diode ED1 and the emission layer 222b' of the second light-emitting diode ED2 may each include an inorganic material or quantum dots.

The intermediate layer 222 may include a first function layer 222a disposed under the emission layers 222b and 222b' and/or a second function layer 222c above the emission layers 222b and 222b'. The first function layer 222a may be a hole transport layer (HTL) having a single layer structure. Alternatively, the first function layer 222a may include a hole injection layer (HIL) and the HTL. The second function layer 222c may include an electron transport layer (ETL) and/or an electron injection layer (EIL). The first function layer 222a and the second function layer 222c may each entirely cover the first display area DA1 and the second display area DA2. In an embodiment, the first function layer 222a and/or the second function layer 222c may be omitted.

The counter electrode 223 may be disposed on the intermediate layer 222. The counter electrode 223 may include a conductive material having a low work function. In an embodiment, for example, the counter electrode 223 may include a (semi-)transparent layer including Ag, Mg, Al, Pt, Pd, Au, Ni, Nd, Ir, Cr, lithium (Li), calcium (Ca), or an alloy thereof. Alternatively, the counter electrode 223 may further include a layer including ITO, IZO, ZnO, or In₂O₃ on the (semi-)transparent layer including at least one selected from the materials described above. The counter electrode 223 may be integrally formed to cover the first display area DA1 and the second display area DA2.

A capping layer 250 may be disposed on the counter electrode 223. The capping layer 250 may include LiF. Alternatively, the capping layer 250 may include an inorganic insulating material, such as silicon nitride, and/or an organic insulating material. In some embodiments, the capping layer 250 may be omitted.

The first light-emitting diode ED1 and the second light-emitting diode ED2 may each be sealed by the encapsulation layer 300. The encapsulation layer 300 may be disposed on the capping layer 250. The encapsulation layer 300 may prevent external moisture or foreign materials from infiltrating into the first light-emitting diode ED1 and the second light-emitting diode ED2.

The encapsulation layer 300 may include at least one inorganic encapsulation layer and at least one organic encapsulation layer. In an embodiment, for example, the encapsulation layer 300 may include the first inorganic encapsulation layer 310, the organic encapsulation layer 320, and the second inorganic encapsulation layer 330. The first inorganic encapsulation layer 310 and the second inorganic encapsulation layer 330 may each include an inorganic insulating material, such as silicon oxide, silicon nitride, or silicon oxynitride. The first inorganic encapsulation layer 310 and the second inorganic encapsulation layer 330 may each be a single layer or multilayer, each layer therein including at least one selected from the materials described above. The organic encapsulation layer 320 may include a polymer-based material. The polymer-based material may include acrylic resin, epoxy-based resin, polyimide, or polyethylene. In an embodiment, the organic encapsulation layer 320 may include acrylate.

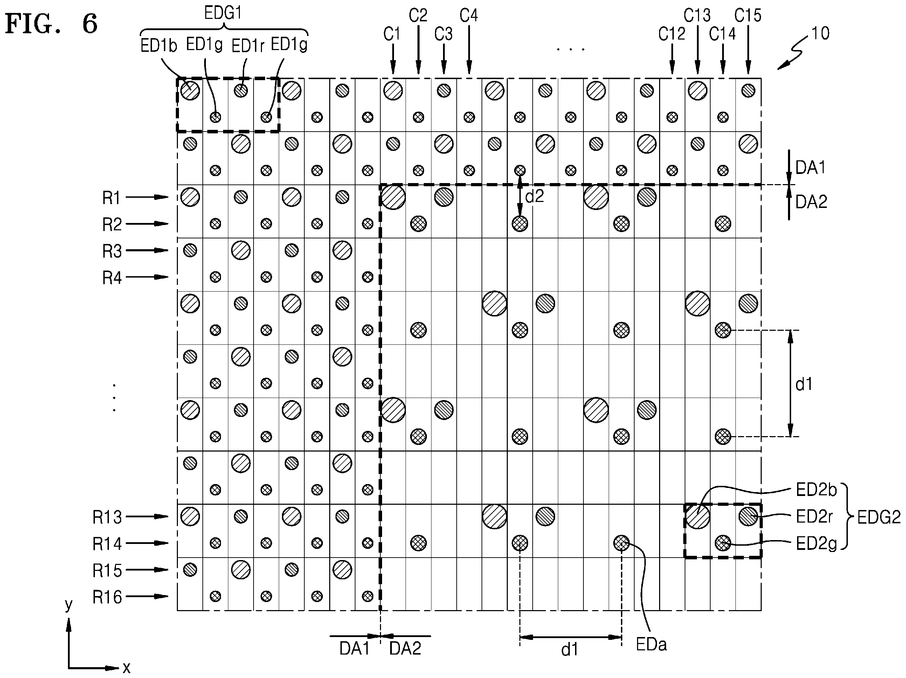

FIG. 6 is a schematic plan view of the display panel 10 according to an embodiment.

In an embodiment, as illustrated in FIG. 6, the display panel 10 may further include an auxiliary light-emitting diode EDa arranged in the second display area DA2, in addition to the first light-emitting diode ED1 (see FIG. 5) arranged in the first display area DA1 and the second light-emitting diode ED2 (see FIG. 5) arranged in the second display area DA2. The auxiliary light-emitting diode EDa may indicates a light-emitting diode arranged in the transmissive area TA (see FIG. 1). The size, shape, and location of the light-emitting diode illustrated in FIG. 6 indicate the size, shape, and location of an emission area of the light-emitting diode.

Referring to FIG. 6, a plurality of first light-emitting diode groups EDG1 may be repeatedly arranged in the first display area DA1 in the first direction (x direction) and the second direction (y direction). The first light-emitting diode groups EDG1 may be repeated units of the first light-emitting diodes ED1 described with reference to FIG. 5. Each of the first light-emitting diode groups EDG1 may include one first red light-emitting diode ED1r, one first blue light-emitting diode ED1b, and two first green light-emitting diodes ED1g. The first red light-emitting diode ED1r, the first blue light-emitting diode ED1b, and the first green light-emitting diode ED1g may emit red, blue, and green light, respectively.

The first blue light-emitting diodes ED1b, the first red light-emitting diodes ED1r, and the first green light-emitting diodes ED1g may be arranged in the first display area DA1 to form a matrix in the first direction (x direction) and the second direction (y direction). The first blue light-emitting diode ED1b and the first red light-emitting diode ED1r may be alternately arranged in odd-numbered rows, and the first green light-emitting diode ED1g may be repeatedly arranged in even-numbered rows. The first blue light-emitting diode ED1b and the first red light-emitting diode ED1r may be alternately arranged in odd-numbered columns, and the first green light-emitting diode ED1g may be repeatedly arranged in even-numbered columns.

In other words, in the first display area DA1, the first blue light-emitting diodes ED1b, the first red light-emitting diodes ED1r, and the first green light-emitting diodes ED1g may be arranged in a PenTile^{®} structure. In an embodiment, for example, among the vertices of an imaginary rectangle with the center point of the first green light-emitting diode ED1g as the center point of the rectangle, one first blue light-emitting diode ED1b may be located at each of the first and third vertices facing each other, and one first red light emitting diode ED1r may be located at each of the second and fourth vertices that are the remaining vertices. The size of the first green light-emitting diode ED1g may be less than the size of the first red light-emitting diode ED1r and the size of the first blue light-emitting diode ED1b.

In the second display area DA2, a plurality of second light-emitting diode groups EDG2 may be repeatedly arranged in the first direction (x direction) and the second direction (y direction). The second light-emitting diode group EDG2 may be a repeated unit of the second light-emitting diodes ED2 described with reference to FIG. 5. As the second light-emitting diodes ED2 are arranged in the non-transmissive area NTA (see FIG. 5) outside the transmissive area TA (see FIG. 1), the second light-emitting diode groups EDG2 may also be arranged in the non-transmissive area NTA. The second light-emitting diode group EDG2 may include one second red light-emitting diode ED2r, one second blue light-emitting diode ED2b, and one second green light-emitting diode ED2g. The second red light-emitting diode ED2r, the second blue light-emitting diode ED2b, and the second green light-emitting diode ED2g may emit red, blue, and green light, respectively.

In an embodiment, the size (or area) of the second red light-emitting diode ED2r may be greater than the size (or area) of the first red light-emitting diode ED1r. The size (or area) of the second blue light-emitting diode ED2b may be greater than the size (or area) of the first blue light-emitting diode ED1b. The size (or area) of the second green light-emitting diode ED2g may be greater than the size (or area) of the first green light-emitting diode ED1g.

In an embodiment, one auxiliary light-emitting diode EDa may be arranged between the second light-emitting diode groups EDG2 neighboring in the first direction (x direction). In such an embodiment, one auxiliary light-emitting diode EDa may be arranged between the second light-emitting diode groups EDG2 neighboring in the second direction (y direction). The auxiliary light-emitting diodes EDa may each be arranged in the transmissive area TA. In other words, the second light-emitting diode groups EDG2 and the auxiliary light-emitting diodes EDa may be alternately arranged in the first direction (x direction) and the second direction (y direction).

In an embodiment, the auxiliary light-emitting diode EDa may emit green light. The auxiliary light-emitting diode EDa may be a green light-emitting diode. The size (or area) of the auxiliary light-emitting diode EDa may be substantially the same as the size (or area) of the second green light-emitting diode ED2g. As the green light has high visibility, in an embodiment, the auxiliary light-emitting diode EDa is provided as a green light-emitting diode, such that the image quality of the second display area DA2 may be further improved.

The second red light-emitting diodes ED2r, the second blue light-emitting diodes ED2b, and the second green light-emitting diodes ED2g, and the auxiliary light-emitting diodes EDa may be arranged to form a matrix in the first direction (x direction) and the second direction (y direction). The second red light-emitting diode ED2r and the second blue light-emitting diode ED2b may be arranged in some of the odd-numbered rows, and the second green light-emitting diode ED2g and the auxiliary light-emitting diode EDa may be arranged in some of the even-numbered rows.

In an embodiment, for example, the second red light-emitting diode ED2r and the second blue light-emitting diode ED2b may be alternately arranged in the (4m-3)-th rows (R1, R5, R9, R13, ... ) of the odd-numbered rows, and the second green light-emitting diode ED2g and the auxiliary light-emitting diode EDa may be arranged in the (4m-2)-th rows (R2, R6, R10, R14, ... ) of the even-numbered rows. Here, m may be a natural number greater than or equal to 1. The second blue light-emitting diodes ED2b may be repeatedly arranged in the (4n-3)-th columns (C1, C5, C9, C13, ... ) of the odd-numbered columns, and the second red light-emitting diodes ED2r may be repeatedly arranged in the (4n-1)-th columns (C3, C7, C11, C15 ... ) of the odd-numbered columns. The second green light-emitting diode ED2g and the auxiliary light-emitting diode EDa may be alternately arranged in (4n-2)-th columns (C2, C6, C10, C14, ...) of the even-numbered columns. Here, n may be a natural number greater than or equal to 1.

In the second display area DA2, the second green light-emitting diode ED2g and the auxiliary light-emitting diode EDa may be arranged in the first direction (x direction) and the second direction (y direction) apart from each other at equal intervals in a plan view (or when viewed in the third direction). In an embodiment, for example, the second green light-emitting diode ED2g and the auxiliary light-emitting diode EDa neighboring in the first direction (x direction) may be apart from each other by a first distance d1 in the first direction (x direction), and the second green light-emitting diode ED2g and the auxiliary light-emitting diode EDa neighboring in the second direction (y direction) may be apart from each other by the first distance d1 in the second direction (y direction).

In an embodiment, the first blue light-emitting diode ED1b, the first red light-emitting diode ED1r, the second blue light-emitting diode ED2b and the second red light-emitting diode ED2r, which are arranged in a same row, may be arranged on an imaginary straight line extending in the first direction (x direction). The first green light-emitting diode ED1g, the second green light-emitting diode ED2g, and the auxiliary light-emitting diode EDa, which are arranged in a same row, may be arranged on an imaginary straight line extending in the first direction (x direction). The first blue light-emitting diode ED1b, the first red light-emitting diode ED1r, and the second blue light-emitting diode ED2b, which are arranged in a same column, may be arranged on an imaginary straight line extending in the second direction (y direction). The first blue light-emitting diode ED1b, the first red light-emitting diode ED1r, and the second red light-emitting diode ED2r, which are arranged in the same column, may be arranged on an imaginary straight line extending in the second direction (y direction). The first green light-emitting diode ED1g, the second green light-emitting diode ED2g, and the auxiliary light-emitting diode EDa, which are arranged in a same column, may be arranged on an imaginary straight line extending in the second direction (y direction).

In an embodiment, the first green light-emitting diode ED1g and the second green light-emitting diode ED2g, which neighbor with each other at a boundary between the first display area DA1 and the second display area DA2, may be apart from each other by second distance d2. In such an embodiment, the first green light-emitting diode ED1g and the auxiliary light-emitting diode EDa, which neighbor with each other at the boundary between the first display area DA1 and the second display area DA2, may be apart from each other by the second distance d2. The second distance d2 is about 50 micrometers (µm) and may be similar to or substantially the same as a separation distance between the first green light-emitting diodes ED1g neighboring in the first display area DA1. Accordingly, the boundary visibility between the first display area DA1 and the second display area DA2 may be improved.

In an embodiment, the second display area DA2 includes the transmissive areas TA (see FIG. 1), such that the resolution of the second display area DA2 may be less or lower than the resolution of the first display area DA1. In embodiments, by arranging the second green light-emitting diodes ED2g in the non-transmissive area NTA of the second display area DA2 and further providing the auxiliary light-emitting diodes EDa in a middle portion of the transmissive areas TA, the resolution of the second display area DA2 may be improved. In an embodiment, for example, the number of light-emitting diodes per unit area in the second display area DA2 may be 1/4 of the number of light-emitting diodes per unit area in the first display area DA1.

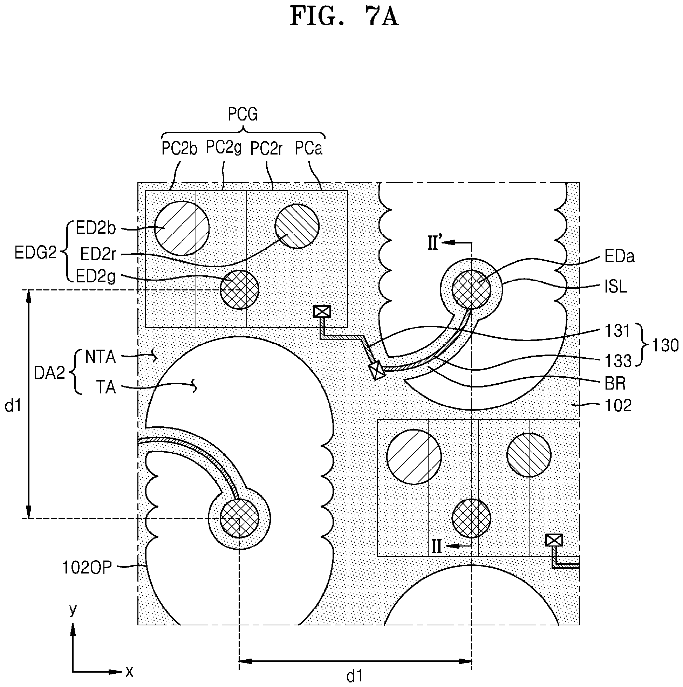

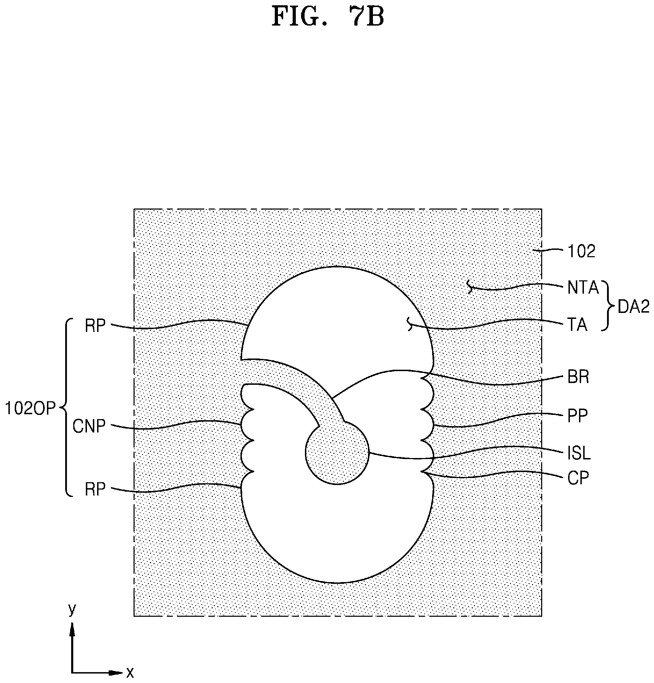

FIG. 7A is a schematic a plan view of the display panel 10 according to an embodiment, and FIG. 7B is a schematic plan view of a second lower metal layer 102 according to an embodiment.

FIG. 7A is a view for describing the arrangement of the second light-emitting diode group EDG2 illustrated in FIG. 6, and FIG. 7B is a view showing an excerpt from the second lower metal layer 102.

Referring to FIGS. 7A and 7B together, the second display area DA2 may include the transmissive areas TA and the non-transmissive area NTA outside the transmissive areas TA. The second lower metal layer 102 is arranged in the second display area DA2, and the second lower metal layer 102 may define the first openings 102OP overlapping the transmissive areas TA. The boundary of each first opening 102OP may substantially match the corresponding boundary of the transmissive area TA. In other words, the transmissive area TA may be defined as an area through which light or sound passes via the first opening 102OP. The non-transmissive area NTA may be defined as an area in which a metal material part (metal part) of the second lower metal layer 102 is located. In an embodiment, the non-transmissive area NTA may overlap a thin or small portion of the second lower metal layer 102 that may not substantially affect the transmittance of the light or sound therethrough, e.g., the bridge portions BR or the island portions ISL shown in FIG. 7B.

In an embodiment, as illustrated in FIGS. 7A and 7B, the first opening 102OP may have an oval shape or a capsule shape in a plan view. In such an embodiment, an overall shape of the first opening 102OP in a plan view may be oval. The capsule shape may mean a shape including two round portions RP, each having a semi-circular shape, arranged to face each other in the second direction (y direction) and a connection portion CNP connecting the two round portions RP. At least a portion of the boundary of the first opening 102OP may have an embossed shape. At least a portion of the boundary of the first opening 102OP, for example, the boundaries of the connection portion CNP, may have a structure in which protruding portions PP are arranged adjacent to each other. The protruding portions PP may each have an approximately semi-circular shape, and pointed portions CP toward the inside of the first opening 102OP may be provided between the protruding portions PP. The pointed portions CP may have a relatively pointed horn shape. In another embodiment, the protruding portion PP may have various shapes, such as a semi-oval shape, a triangular shape, and a quadrangle shape.

When at least a portion of the boundary of the first opening 102OP (or the boundary of the second lower metal layer 102 defining the first opening 102OP) includes the protruding portions PP, the diffraction of light emitted from the component 40 (see FIG. 2) or traveling toward the component 40 through the first opening 102OP may be substantially reduced.

One auxiliary light-emitting diode EDa may be arranged inside (or in a middle or inner portion of) each of the transmissive areas TA of the second display area DA2, in a plan view. The auxiliary light-emitting diode EDa may be arranged in a center area of the transmissive area TA or in an area apart from the center area in the second direction (y direction) by a certain distance.

The second lower metal layer 102 may include island portions ISL respectively overlapping the auxiliary light-emitting diodes EDa and bridge portions BR extending from the island portions ISL toward the corresponding boundary of the first opening 102OP. In other words, one island portion ISL and one bridge portion BR extending from the island portion ISL may be arranged inside each of the transmissive areas TA.

The island portion ISL may have an approximately circular or oval shape in a plan view. The bridge portion BR may have an approximately arc shape in a plan view. In an embodiment, for example, the bridge portion BR may have a first boundary and a second boundary facing the first boundary, and the first boundary may have a first radius of curvature, and the second boundary may have a second radius of curvature greater than the first radius of curvature. As the bridge portion BR has, in a plan view, an approximately arc shape, diffraction of the light emitted from the component 40 or traveling toward the component 40 through the first opening 102OP may be substantially reduced. In another embodiment, the bridge portion BR may have a straight shape.

The second light-emitting diode group EDG2 and a sub-pixel circuit group PCG may be arranged in the non-transmissive area NTA of the second display area DA2. The second light-emitting diode group EDG2 may include the second blue light-emitting diode ED2b, the second red light-emitting diode ED2r, and the second green light-emitting diode ED2g which are arranged in the non-transmissive area NTA. The sub-pixel circuit group PCG may include a second blue sub-pixel circuit PC2b electrically connected to the second blue light-emitting diode ED2b, a second red sub-pixel circuit PC2r electrically connected to the second red light-emitting diode ED2r, a second green sub-pixel circuit PC2g electrically connected to the second green light-emitting diode ED2g, and an auxiliary sub-pixel circuit PCa electrically connected to the auxiliary light-emitting diode EDa. The second blue sub-pixel circuit PC2b, the second red sub-pixel circuit PC2r, the second green sub-pixel circuit PC2g, and the auxiliary sub-pixel circuit PCa may each include one driving thin film transistor.

The auxiliary light-emitting diode EDa, which is arranged in the transmissive area TA, may be apart from the auxiliary sub-pixel circuit PCa arranged in the non-transmissive area NTA. Accordingly, the auxiliary light-emitting diode EDa may be electrically connected to the auxiliary sub-pixel circuit PCa via a connection wire 130. The connection wire 130 may include a first sub-wire 131 connected to the auxiliary sub-pixel circuit PCa and a second sub-wire 133 connected to the auxiliary light-emitting diode EDa. The first sub-wire 131 may be arranged in the non-transmissive area NTA, and the second sub-wire 133 may be arranged in the transmissive area TA. The second sub-wire 133 may be arranged overlapping the bridge portion BR of the second lower metal layer 102 and may have a shape corresponding to the shape of the bridge portion BR. In an embodiment, the second sub-wire 133 may have an arc shape, in a plan view.

Although FIGS. 7A and 7B illustrate an embodiment where the bridge portion BR overlapping the second sub-wire 133 is included in the second lower metal layer 102, the disclosure is not limited thereto. In another embodiment, the bridge portion BR may be formed using other conductive layers disposed under the second sub-wire 133.

In another embodiment, the auxiliary sub-pixel circuit PCa may be omitted. In an embodiment, for example, the sub-pixel circuit group PCG may include only the second blue sub-pixel circuit PC2b, the second red sub-pixel circuit PC2r, and the second green sub-pixel circuit PC2g. In such an embodiment, the auxiliary light-emitting diode EDa may be electrically connected to the second green sub-pixel circuit PC2g. In an embodiment, for example, the first sub-wire 131 of the connection wire 130 may be connected to the second green sub-pixel circuit PC2g or the second green light-emitting diode ED2g. The auxiliary light-emitting diode EDa may emit light simultaneously with the second green light-emitting diode ED2g by a same scan signal and a same data signal.

The second green light-emitting diode ED2g and the auxiliary light-emitting diode EDa neighboring in the first direction (x direction) may be apart from each other in the first direction (x direction) by the first distance d1, and the second green light-emitting diode ED2g and the auxiliary light-emitting diode EDa neighboring in the second direction (y direction) may be apart from each other in the second direction (y direction) by the first distance d1. In other words, in the second display area DA2, the second green light-emitting diodes ED2g and the auxiliary light-emitting diodes EDa may be alternately arranged at equal intervals in the first direction (x direction) and the second direction (y direction) in a plan view. As the second green light-emitting diodes ED2g and the auxiliary light-emitting diodes EDa, which emit green light with high visibility, are arranged at equal intervals in the first direction (x direction) and the second direction (y direction), the display quality of an image displayed by the second display area DA2 may be improved.

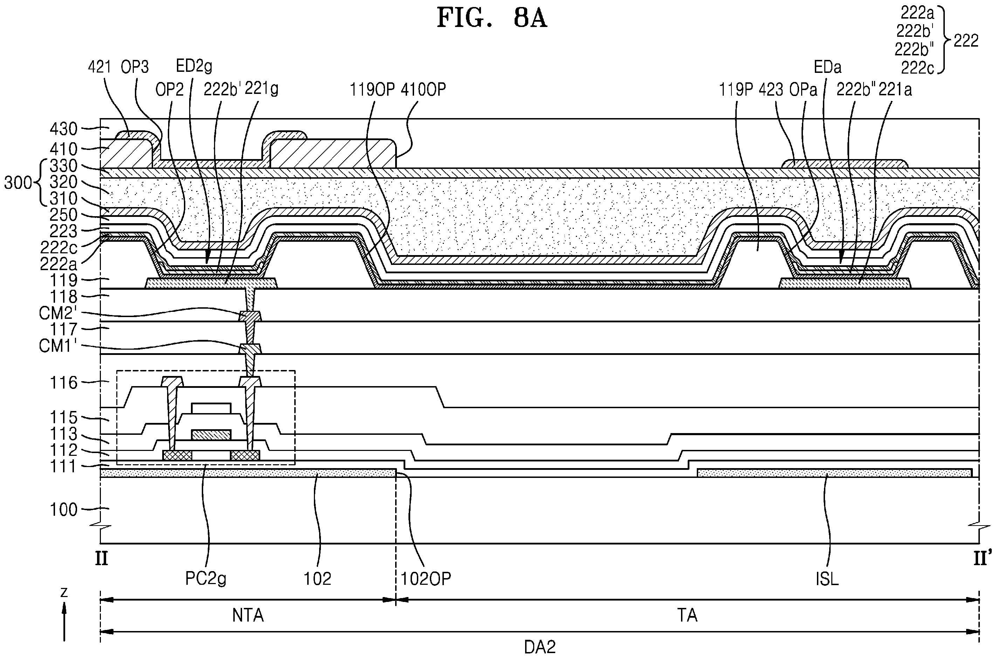

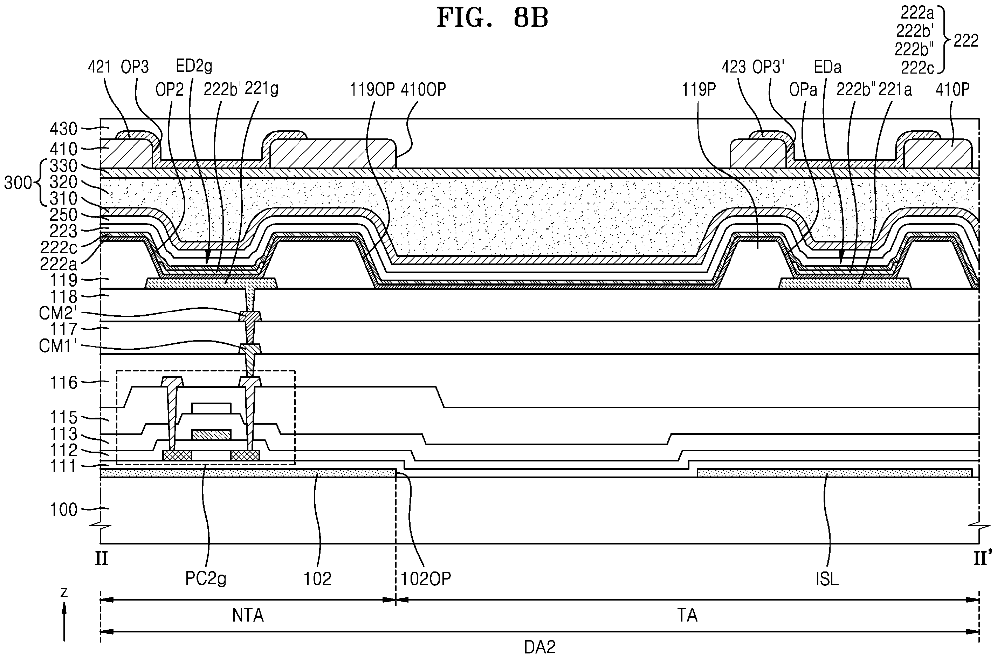

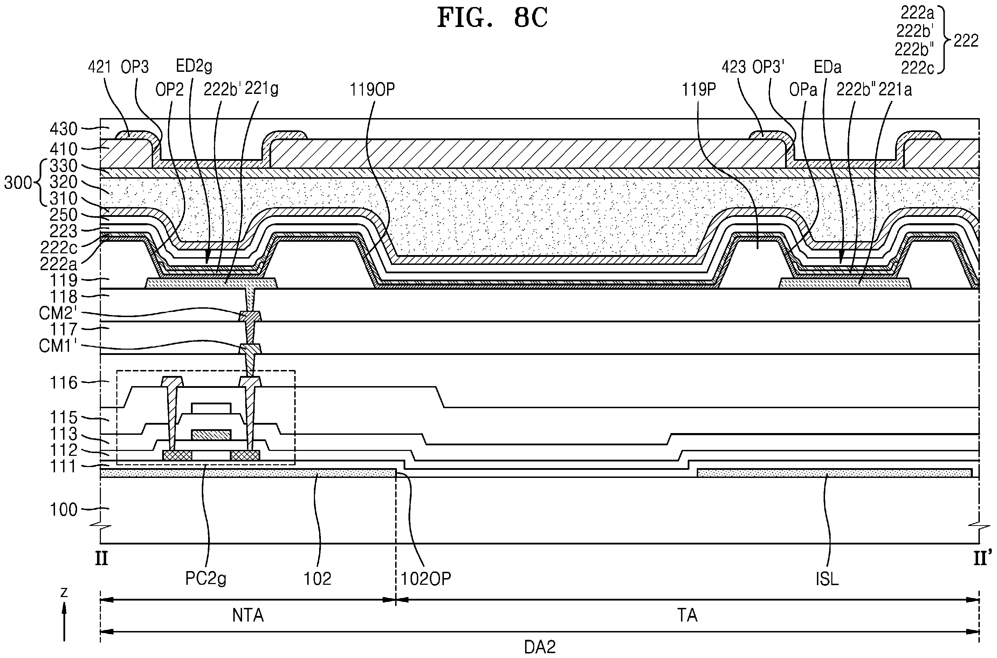

FIGS. 8A, 8B, and 8C are schematic cross-sectional views of the display panel 10 of FIG. 7A taken along line II-II'.

Referring to FIG. 8A, in an embodiment, the substrate 100 may include the second display area DA2. The second display area DA2 may include the transmissive areas TA through which light or sound passes and the non-transmissive area NTA outside the transmissive areas TA. The second green sub-pixel circuit PC2g and the second green light-emitting diode ED2g electrically connected to the second green sub-pixel circuit PC2g may be arranged in the non-transmissive area NTA. The auxiliary light-emitting diode EDa may be arranged in the transmissive area TA. In order to improve the transmittance of the transmissive area TA, a sub-pixel circuit may not be arranged in the transmissive area TA.

The second lower metal layer 102 may be disposed between the substrate 100 and the buffer layer 111. The second lower metal layer 102 may be arranged in the second display area DA2 and may define the first openings 102OP overlapping the transmissive areas TA. The second lower metal layer 102 may include the island portion ISL arranged inside the first opening 102OP and overlapping the auxiliary light-emitting diode EDa and the bridge portion BR (see FIG. 7A) extending from the island portion ISL.

The second green sub-pixel circuit PC2g may be disposed on the buffer layer 111. The first planarization layer 116, the second planarization layer 117, and the third planarization layer 118 may be disposed on the second green sub-pixel circuit PC2g, and the second green light-emitting diode ED2g and the auxiliary light-emitting diode EDa may be disposed on the third planarization layer 118.

The second green light-emitting diode ED2g may include a pixel electrode 221g, the counter electrode 223, and the intermediate layer 222 between the pixel electrode 221g and the counter electrode 223. The auxiliary light-emitting diode EDa may include an auxiliary pixel electrode 221a, the counter electrode 223, and the intermediate layer 222 between the auxiliary pixel electrode 221a and the counter electrode 223.

The pixel electrode 221g of the second green light-emitting diode ED2g and the auxiliary pixel electrode 221a may be disposed on the third planarization layer 118. The pixel electrode 221g of the second green light-emitting diode ED2g may be electrically connected to the second green sub-pixel circuit PC2g through the first contact electrode CM1' between the first planarization layer 116 and the second planarization layer 117 and the second contact electrode CM2' between the second planarization layer 117 and the third planarization layer 118.

The auxiliary pixel electrode 221a may be electrically connected to the sub-pixel circuit arranged in the non-transmissive area NTA via the connection wire 130 (see FIG. 7A). In an embodiment, the sub-pixel circuit group PCG (see FIG. 7A) arranged in the non-transmissive area NTA may include the auxiliary sub-pixel circuit PCa (see FIG. 7A), and the auxiliary pixel electrode 221a may be electrically connected to the auxiliary sub-pixel circuit PCa via the connection wire 130. In another embodiment, the auxiliary pixel electrode 221a may be electrically connected to the pixel electrode 221g of the second green light-emitting diode ED2g adjacent to the auxiliary pixel electrode 221a via the connection wire 130, or the second green sub-pixel circuit PC2g adjacent to the auxiliary pixel electrode 221a.

The bank layer 119 may cover the edge of the pixel electrode 221g of the second green light-emitting diode ED2g. The bank layer 119 may define the second pixel opening OP2 that exposes the center area of the pixel electrode 221g of the second green light-emitting diode ED2g. The second pixel opening OP2 may define the emission area of the second green light-emitting diode ED2g.

The bank layer 119 may define an opening 119OP overlapping the transmissive area TA and include, in a plan view, a first portion 119P arranged within the opening 119OP. The opening 119OP of the bank layer 119 may overlap the first opening 102OP of the second lower metal layer 102, and the first portion 119P may overlap the island portion ISL of the second lower metal layer 102. The first portion 119P of the bank layer 119 may cover the edge of the auxiliary pixel electrode 221a and define an auxiliary pixel opening OPa that exposes the center area of the auxiliary pixel electrode 221a. The auxiliary pixel opening OPa may define the emission area of the auxiliary light-emitting diode EDa. In an embodiment, the first portion 119P of the bank layer 119 may have an isolated shape (island type). In another embodiment, the bank layer 119 may further include a bridge portion (not shown) extending from the first portion 119P. The bridge portion of the bank layer 119 may have a shape corresponding to the bridge portion BR (see FIG. 7A) of the second lower metal layer 102.

The intermediate layer 222 may be disposed on the bank layer 119. The intermediate layer 222 may include the emission layer 222b' of the second green light-emitting diode ED2g and an emission layer 222b" of the auxiliary light-emitting diode EDa. The emission layer 222b' of the second green light-emitting diode ED2g may be disposed to overlap the pixel electrode 221g of the second green light-emitting diode ED2g through the second pixel opening OP2, and the emission layer 222b" of the auxiliary light-emitting diode EDa may be disposed to overlap the auxiliary pixel electrode 221a through the auxiliary pixel opening OPa. The emission layer 222b' of the second green light-emitting diode ED2g and the emission layer 222b" of the auxiliary light-emitting diode EDa may each include a polymer or low molecular weight organic material that emits green light. The intermediate layer 222 may include the first function layer 222a disposed under the emission layers 222b' and 222b" and/or the second function layer 222c disposed above the emission layers 222b' and 222b".

The counter electrode 223 may be disposed on the intermediate layer 222. The counter electrode 223 may be integrally provided to cover the pixel electrode 221g of the second green light-emitting diode ED2g and the auxiliary pixel electrode 221a. The capping layer 250 may be formed on the counter electrode 223. The encapsulation layer 300 may be disposed on the capping layer 250. The encapsulation layer 300 may include the first inorganic encapsulation layer 310, the organic encapsulation layer 320, and the second inorganic encapsulation layer 330.

A color filter layer may be disposed on the encapsulation layer 300. The color filter layer may include a light shielding layer 410, a first color filter 421 disposed to correspond to the second green light-emitting diode ED2g, a second color filter 423 disposed to correspond to the auxiliary light-emitting diode EDa, and a coating layer 430.

The light shielding layer 410 may define first filter openings OP3 overlapping the second light-emitting diode groups EDG2 (see FIG. 7A) and second openings 410OP overlapping the transmissive areas TA. The first filter openings OP3 overlapping the second light-emitting diode groups EDG2 means that each first filter opening OP3 is arranged corresponding to the second blue light-emitting diode ED2b (see FIG. 7A), the second red light-emitting diode ED2r (see FIG. 7A), or the second green light-emitting diode ED2g. In such an embodiment, each of the second openings 410OP may be arranged corresponding to one transmissive area TA. The first filter opening OP3 may be disposed to correspond to the second pixel opening OP2. The second opening 410OP of the light shielding layer 410 may be disposed to overlap the first opening 102OP of the second lower metal layer 102.

The first color filters 421 may be disposed to correspond to the second light-emitting diode groups EDG2. The first color filters 421 being disposed to correspond to the second light-emitting diode groups EDG2 may mean that the first color filters 421 include red color filters, blue color filters, and green color filters, and that each of the red color filters is disposed to correspond to each of the second red light-emitting diodes ED2r, each of the blue color filters is disposed to correspond to each of the second blue light-emitting diodes ED2b, and each of the green color filters is disposed to correspond to each of the second green light-emitting diodes ED2g.

FIG. 8A illustrates an embodiment where the first color filter 421 is disposed to correspond to the second green light-emitting diode ED2g. The first color filter 421 may be disposed to overlap the first filter opening OP3 of the light shielding layer 410. The second color filter 423 may be disposed to correspond to the auxiliary light-emitting diode EDa. As the second color filter 423 is arranged within the second opening 410OP of the light shielding layer 410, the light shielding layer 410 may not be disposed between the second inorganic encapsulation layer 330 and the second color filter 423. As the light shielding layer 410 does not overlap the transmissive area TA, the light transmittance of the transmissive area TA may be improved.

The first color filter 421 and the second color filter 423 may each be a layer that selectively transmits only light of a wavelength belonging to a certain range. In an embodiment, for example, the first color filter 421 and the second color filter 423 may each be a layer that selectively transmits only light of a wavelength belonging to a range from about 495 nanometers (nm) to about 570 nm. The first color filter 421 and the second color filter 423 may each improve the quality of an image that is displayed by increasing color purity of light emitted to the outside. The coating layer 430 may be disposed on the first color filter 421 and the second color filter 423.

Referring to FIG. 8B, in another embodiment, the light shielding layer 410 may define the first filter openings OP3 overlapping the second light-emitting diode groups EDG2 (see FIG. 7A) and the second openings 410OP overlapping the transmissive areas TA. The light shielding layer 410 may further include second portions 410P inside the second openings 410OP, and each of the second portions 410P may define a second filter opening OP3' overlapping the auxiliary light-emitting diode EDa located thereunder.

The first color filters 421 may be disposed to correspond to the second light-emitting diode groups EDG2. FIG. 8B illustrates an embodiment where the first color filter 421 is disposed to correspond to the second green light-emitting diode ED2g. The first color filter 421 may be disposed to overlap the first filter opening OP3 of the light shielding layer 410. The second color filter 423 may be disposed to correspond to the auxiliary light-emitting diode EDa. The second color filter 423 may be disposed to overlap the second filter opening OP3' of the second portion 410P of the light shielding layer 410.

The second portion 410P of the light shielding layer 410 may reduce a rate at which external light incident on the display panel 10 is reflected by components under the second portion 410P, for example, components of the auxiliary light-emitting diode EDa, and then is emitted again to the outside, thereby reducing external light reflection.

Referring to FIG. 8C, in another embodiment, the light shielding layer 410 may define the first filter openings OP3 overlapping the second light-emitting diode groups EDG2 (see FIG. 7A) and the second filter openings OP3' overlapping the auxiliary light-emitting diodes EDa. The light shielding layer 410 may cover the transmissive area TA. In an embodiment, for example, where the component 40 (see FIG. 2) is an infrared sensor, the light shielding layer 410 may cover the transmissive area TA outside the second filter opening OP3' by using a black matrix material with a high infrared transmittance. In such an embodiment, the light shielding layer 410 may include a black matrix material that selectively transmits only light of a wavelength belonging to a certain range. In an embodiment, for example, the light shielding layer 410 may include a black matrix material including a lactam-based pigment, that is, a material with a transmittance of about 90 % or greater for infrared rays having a wavelength of about 940 nm. The light shielding layer 410 may reduce external light reflection by reducing a rate at which visible light incident on the display panel 10 is reflected by components under the light shielding layer 410 and then emitted again to the outside, while transmitting infrared rays emitted from the component 40 or traveling toward the component 40. The light emitted by the auxiliary light-emitting diode EDa may be emitted through the second filter opening OP3' of the light shielding layer 410.

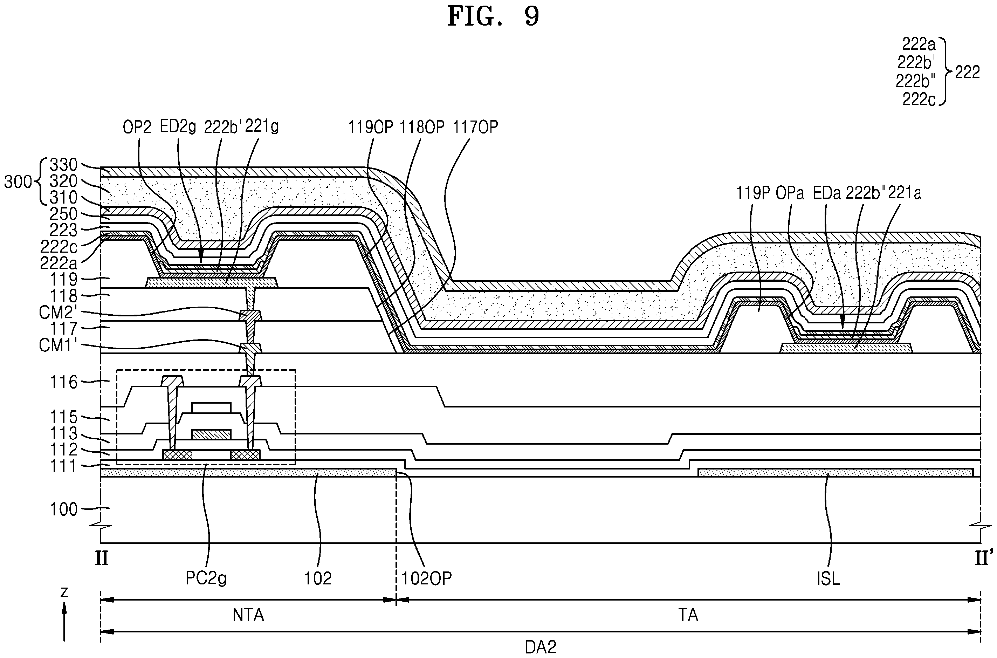

FIG. 9 is a schematic cross-sectional view of the display panel 10 according to an embodiment.

The display panel shown in FIG. 9 is substantially the same as the display panel shown in FIGS. 8A to 8C, except that the second planarization layer 117 and the third planarization layer 118 respectively define openings 117OP and 118OP overlapping the transmissive areas TA. In FIG. 9, for convenience, illustration of the color filter layer is omitted. Any repetitive detailed descriptions of the same or similar components as those described above are omitted, and differences are mainly described below.

Referring to FIG. 9, in an embodiment, the second planarization layer 117 may define the openings 117OP overlapping the transmissive areas TA, respectively, and the third planarization layer 118 may define the openings 118OP overlapping the transmissive areas TA, respectively. The opening 117OP of the second planarization layer 117 and the opening 118OP of the third planarization layer 118 may overlap the first opening 102OP of the second lower metal layer 102 and the opening 119OP of the bank layer 119, respectively. In such an embodiment where the opening 117OP of the second planarization layer 117 and the opening 118OP of the third planarization layer 118 are arranged in the transmissive area TA, the light transmittance of the transmissive area TA may be improved.

The auxiliary light-emitting diode EDa may be disposed within the opening 117OP of the second planarization layer 117 and the opening 118OP of the third planarization layer 118. In other words, the auxiliary pixel electrode 221a of the auxiliary light-emitting diode EDa may be disposed on the first planarization layer 116. The pixel electrode 221g of the second green light-emitting diode ED2g and the auxiliary pixel electrode 221a of the auxiliary light-emitting diode EDa may be disposed at different heights from an upper surface of the substrate 100.

The first portion 119P of the bank layer 119 may be disposed on the first planarization layer 116 to cover the edge of the auxiliary pixel electrode 221a of the auxiliary light-emitting diode EDa. The first portion 119P of the bank layer 119 may define the auxiliary pixel opening OPa that exposes the center area of the auxiliary light-emitting diode EDa.

Although FIG. 9 illustrates an embodiment where the second planarization layer 117 and the third planarization layer 118 define the openings 117OP and 118OP overlapping the transmissive area TA, the disclosure is not limited thereto. In another embodiment, only one of the second planarization layer 117 and the third planarization layer 118 may define an opening that overlaps the transmissive area TA. In another embodiment, the first planarization layer 116 may define an opening overlapping the transmissive area TA, and the second planarization layer 117 or the third planarization layer 118 may cover the transmissive area TA.

To seal the auxiliary light-emitting diode EDa and the second green light-emitting diode ED2g, the encapsulation layer 300 may be disposed on the auxiliary light-emitting diode EDa and the second green light-emitting diode ED2g. The color filter layer described with reference to FIGS. 8A to 8C may be disposed on the encapsulation layer 300.

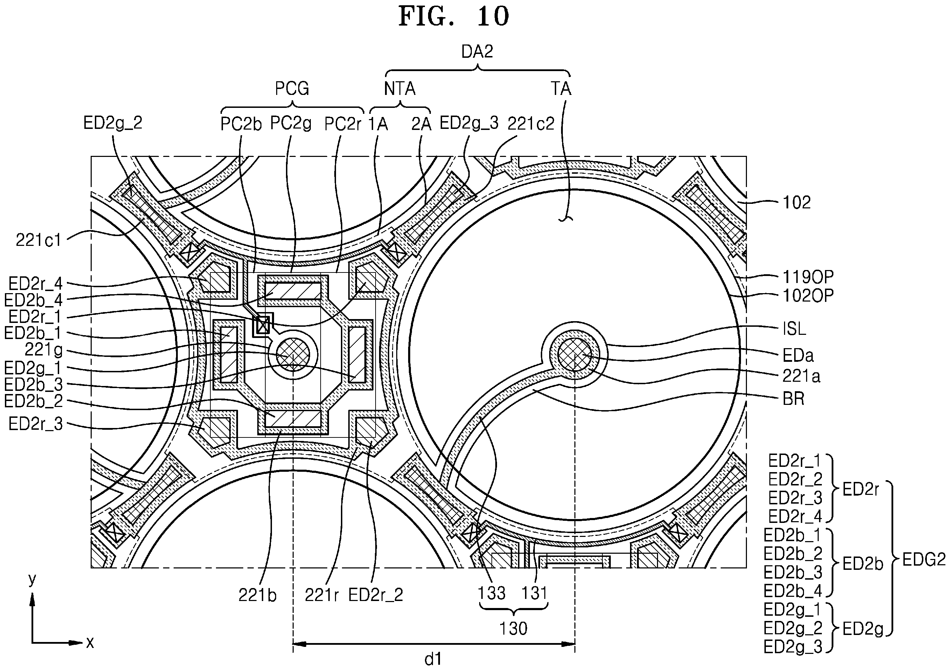

FIG. 10 is a schematic plan view of the display panel 10 according to an embodiment.

Referring to FIG. 10, in an embodiment, the second display area DA2 may include the transmissive areas TA and the non-transmissive area NTA outside the transmissive areas TA. The non-transmissive area NTA may include a plurality of first areas 1A, in which the sub-pixel circuit groups PCG are arranged, and the second area 2A outside the first areas 1A.

The second lower metal layer 102 may be arranged in the second display area DA2, and the second lower metal layer 102 may define the first openings 102OP overlapping (or defining) the transmissive areas TA, respectively. The first opening 102OP of the second lower metal layer 102 may each have a circular shape, in a plan view. Alternatively, the first openings 102OP of the second lower metal layer 102 may each have an oval shape or a capsule shape, in a plan view. A portion of the boundary of each of the first openings 102OP of the second lower metal layer 102 may include the protruding portions PP (see FIG. 7B).

In an embodiment, four first openings 102OP neighboring each other may be arranged at four vertices of an imaginary rhombus shape having a center at one point of the non-transmissive area NTA. The sub-pixel circuit group PCG may be arranged in a central portion of the imaginary rhombus shape. In other words, one first area 1A may be arranged inside the four transmissive areas TA defined by the four first openings 102OP neighboring each other.

The sub-pixel circuit group PCG may include the second blue sub-pixel circuit PC2b, the second red sub-pixel circuit PC2r, and the second green sub-pixel circuit PC2g. At least one second light-emitting diode group EDG2 may be arranged in each of the first areas 1A of the non-transmissive area NTA. Each of the second light-emitting diode group EDG2 may include the second red light-emitting diodes ED2r, the second blue light-emitting diodes ED2b, and the second green light-emitting diodes ED2g.

The second green light-emitting diodes ED2g may include a first second green light-emitting diode (hereinafter, will be referred to as "second-1 green light-emitting diode") ED2g_1, a second second green light-emitting diode (hereinafter, will be referred to as "second-2 green light-emitting diode") ED2g_2, and a third second green light-emitting diode (hereinafter, will be referred to as "second-3 green light-emitting diode") ED2g_3. The second-1 green light-emitting diode ED2g_1 may be arranged about a center of the first area 1A. The second-2 green light-emitting diode ED2g_2 and the second-3 green light-emitting diode ED2g_3 may be arranged in the second area 2A of the non-transmissive area NTA. The second-2 green light-emitting diode ED2g_2 may be arranged in the second area 2A between an upper transmissive area TA (the transmissive area TA in +y direction) and a left transmissive area TA (the transmissive area TA in -x direction) among the four transmissive areas TA surrounding the first area 1A. The second-3 green light-emitting diode ED2g_3 may be arranged in the second area 2A between the upper transmissive area TA (the transmissive area TA in +y direction) and a right the transmissive area TA (the transmissive area TA in +x direction) among the four transmissive areas TA surrounding the first area 1A.

The second green light-emitting diodes ED2g may be electrically connected to the second green sub-pixel circuit PC2g. The second-1 green light-emitting diode ED2g_1 may be arranged to overlap the sub-pixel circuit group PCG, and the second-2 green light-emitting diode ED2g_2 and the second-3 green light-emitting diode ED2g_3 may be arranged apart from the sub-pixel circuit group PCG, in a plan view. The second-1 green light-emitting diode ED2g_1 may be electrically connected to the second green sub-pixel circuit PC2g. A pixel electrode 221c1 of the second-2 green light-emitting diode ED2g_2 and a pixel electrode 221c2 of the second-3 green light-emitting diode ED2g_3 may be electrically connected to the second green sub-pixel circuit PC2g or the pixel electrode 221g of the second-1 green light-emitting diode ED2g_1 through the first sub-wire 131.

In an embodiment, for example, a pixel electrode 221c1 or 221c2 of each of the second-2 green light-emitting diode ED2g_2 and the second-3 green light-emitting diode ED2g_3 may be electrically connected to the pixel electrode 221g of the second-1 green light-emitting diode ED2g_1 or the second green sub-pixel circuit PC2g through the first sub-wire 131. In the display panel 10, by further arranging the second-2 green light-emitting diode ED2g_2 and the second-3 green light-emitting diode ED2g_3 in the second area 2A between the transmissive areas TA, the resolution of the second display area DA2 may be improved.

The second blue light-emitting diodes ED2b may include a first second blue light-emitting diode (hereinafter, will be referred to as "second-1 blue light-emitting diode") ED2b_1, a second second blue light-emitting diode (hereinafter, will be referred to as "second-2 blue light-emitting diode") ED2b_2, a third second blue light-emitting diode (hereinafter, will be referred to as "second-3 blue light-emitting diode") ED2b_3, and a fourth second blue light-emitting diode (hereinafter, will be referred to as "second-4 blue light-emitting diode") ED2b_4. The second-1 blue light-emitting diode ED2b_1, the second-2 blue light-emitting diode ED2b_2, the second-3 blue light-emitting diode ED2b_3, and the second-4 blue light-emitting diode ED2b_4 may be respectively arranged at four vertices of an imaginary rhombus shape having the second-1 green light-emitting diode ED2g_1 as a center. The second-1 blue light-emitting diode ED2b_1, the second-2 blue light-emitting diode ED2b_2, the second-3 blue light-emitting diode ED2b_3, and the second-4 blue light-emitting diode ED2b_4 may be electrically connected to the second blue sub-pixel circuit PC2b. In an embodiment, the pixel electrodes 221b of the second-1 blue light-emitting diode ED2b_1, the second-2 blue light-emitting diode ED2b_2, the second-3 blue light-emitting diode ED2b_3, and the second-4 blue light-emitting diode ED2b_4 may be electrically connected to one another via the connection wires surrounding the second-1 green light-emitting diode ED2g_1.

The second red light-emitting diodes ED2r may include a first second red light-emitting diode (hereinafter, will be referred to as "second-1 red light-emitting diode") ED2r_1, a second second red light-emitting diode (hereinafter, will be referred to as "second-2 red light-emitting diode") ED2r_2, a third second red light-emitting diode (hereinafter, will be referred to as "second-3 red light-emitting diode") ED2r_3, and a fourth second red light-emitting diode (hereinafter, will be referred to as "second-4 red light-emitting diode") ED2r_4. The second-1 red light-emitting diode ED2r_1, the second-2 red light-emitting diode ED2r_2, the second-3 red light-emitting diode ED2r_3, and the second-4 red light-emitting diode ED2r_4 may be respectively arranged at four vertices of an imaginary square having the second-1 green light-emitting diode ED2g_1 as a center. The second-1 red light-emitting diode ED2r_1, the second-2 red light-emitting diode ED2r_2, the second-3 red light-emitting diode ED2r_3, and the second-4 red light-emitting diode ED2r_4 may be electrically connected to the second red sub-pixel circuit PC2r. In an embodiment, pixel electrodes 221r of the second-1 red light-emitting diode ED2r_1, the second-2 red light-emitting diode ED2r_2, the second-3 red light-emitting diode ED2r_3, and the second-4 red light-emitting diode ED2r_4 may be electrically connected to each other via the connection wires surrounding the second blue light-emitting diodes ED2b. As the light-emitting diodes that emit light of a same color are connected to one sub-pixel circuit, the area of the non-transmissive area NTA is reduced in the second display area DA2, thereby improving the resolution of the second display area DA2 and also maintaining or improving the transmittance of light or sound.

One auxiliary light-emitting diode EDa may be arranged inside each of the transmissive areas TA, in a plan view. The auxiliary light-emitting diode EDa may be arranged in the center area of the transmissive area TA. The second-1 green light-emitting diode ED2g_1 and the auxiliary light-emitting diode EDa adjacent to each other in the first direction (x direction) may be apart from each other in the first direction (x direction) by the first distance d1. In such an embodiment, the second-1 green light-emitting diode ED2g_1 and the auxiliary light-emitting diode EDa adjacent to each other in the second direction (y direction) may be apart from each other in the second direction (y direction) by the first distance d1. In other words, the second-1 green light-emitting diodes ED2g_1 and the auxiliary light-emitting diodes EDa may be alternately arranged in the first direction (x direction) and the second direction (y direction) at equal intervals.

The second lower metal layer 102 may include the island portions ISL respectively overlapping the auxiliary light-emitting diodes EDa and the bridge portions BR extending from the island portions ISL to the corresponding boundary of the first opening 102OP. In other words, one island portion ISL and one bridge portion BR extending from the island portion ISL may be arranged inside each of the transmissive areas TA.

Each island portion ISL may have an approximately circular or oval shape in a plan view. Each bridge portion BR may have an approximately arc shape in a plan view. As the bridge portion BR has an approximately arc shape in a plan view, the diffraction of light emitted from the component 40 (see FIG. 2) or traveling toward the component 40 through the first opening 102OP may be reduced. In another embodiment, each bridge portion BR may have a straight shape.

The bank layer 119 (see FIG. 8A) may define the opening 119OP overlapping the first opening 102OP of the second lower metal layer 102. In an embodiment, although, as illustrated in FIG. 10, the boundary of the opening 119OP of the bank layer 119 may be arranged outside the boundary of the first opening 102OP of the second lower metal layer 102, the disclosure is not limited thereto. The boundary of the opening 119OP of the bank layer 119 may be arranged inside the boundary of the first opening 102OP of the second lower metal layer 102 or may be arranged to substantially match the boundary of the first opening 102OP. In an embodiment where the boundary of the opening 119OP of the bank layer 119 is located outside the boundary of the first opening 102OP of the second lower metal layer 102, the light transmittance of the transmissive area TA may be improved. In an embodiment where the boundary of the opening 119OP of the bank layer 119 is located inside the boundary of the first opening 102OP of the second lower metal layer 102, the external light reflectance of the transmissive area TA may be reduced.

The bank layer may include the first portion 119P (see FIG. 8A) arranged within the opening 119OP of the bank layer 119 and overlapping the island portion ISL of the second lower metal layer 102. In an embodiment, the bank layer 119 may further include a bridge portion overlapping the bridge portion BR of the second lower metal layer 102.

The auxiliary light-emitting diode EDa may be electrically connected to the second green sub-pixel circuit PC2g via the connection wire 130. The connection wire 130 may include the first sub-wire 131 and the second sub-wire 133. The first sub-wire 131 may electrically connect the second green sub-pixel circuit PC2g or the pixel electrode 221g of the second-1 green light-emitting diode ED2g_1 with the pixel electrode 221c1 of the second-2 green light-emitting diode ED2g_2. The second sub-wire 133 may electrically connect the auxiliary pixel electrode 221a of the auxiliary light-emitting diode EDa with the pixel electrode 221c1 of the second-2 green light-emitting diode ED2g_2.

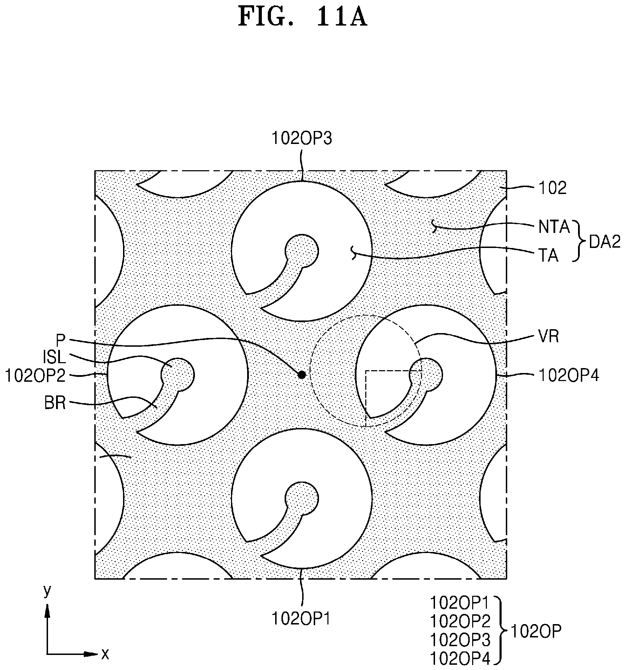

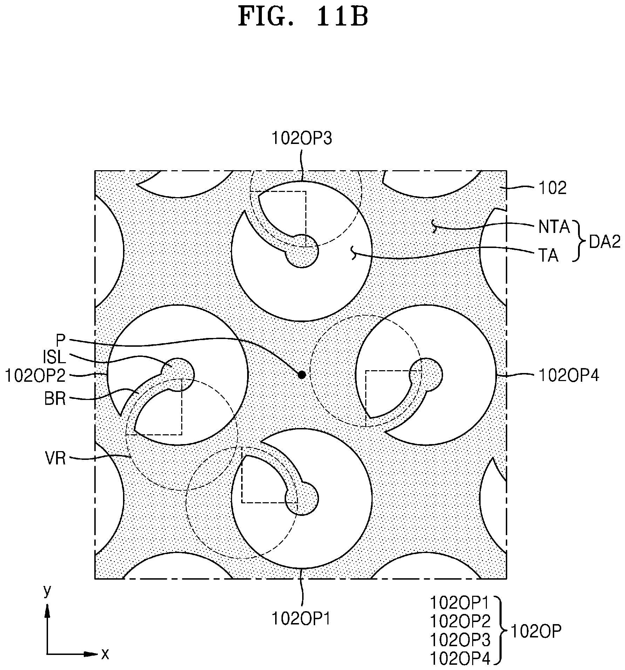

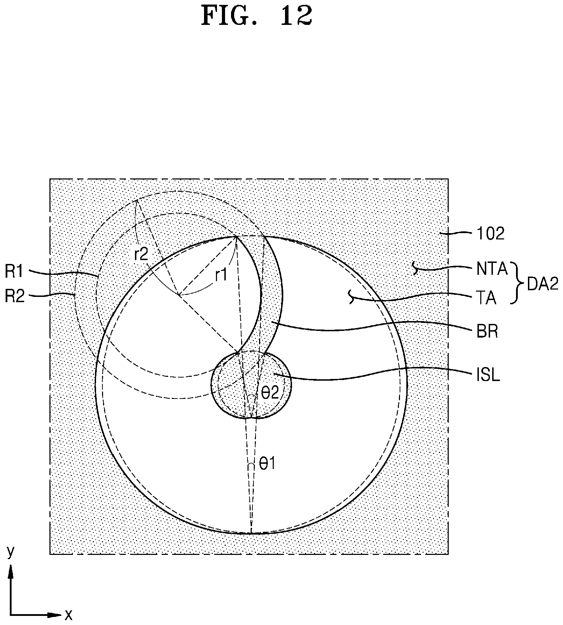

FIGS. 11A and 11B are each a view for explaining the arrangements of a bridge portion BR and an island portion ISL according to an embodiment, and FIG. 12 is a view for explaining the shapes of the bridge portion BR and the island portion ISL.

Referring to FIGS. 11A, 11B, and FIG. 12 together, in an embodiment, the second display area DA2 may include the transmissive areas TA and the non-transmissive area NTA outside the transmissive areas TA. Each transmissive area TA may be surrounded by the non-transmissive area NTA. The second lower metal layer 102 may be arranged in the second display area DA2, and the second lower metal layer 102 may define the first openings 102OP overlapping the transmissive areas TA. The boundary of each first opening 102OP may substantially match the corresponding boundary of the transmissive area TA. In other words, the transmissive area TA may be defined as an area that transmits light or sound through the first opening 102OP. The non-transmissive area NTA may be defined as an area where the metal material part (metal part) of the second lower metal layer 102 is located.

The first opening 102OP may include a first first opening (hereinafter, will be referred to as "first-1 opening") 102OP1, a second first opening (hereinafter, will be referred to as "first-2 opening") 102OP2, a third first opening (hereinafter, will be referred to as "first-3 opening") 102OP3, and a fourth first opening (hereinafter, will be referred to as "first-4 opening") 102OP4 which are arranged to surround one point P of the non-transmissive area NTA. In an embodiment, for example, based on the one point P of the non-transmissive area NTA, the first opening 102OP arranged in the lower (-y direction) side may be defined as the first-1 opening 102OP1, the first opening 102OP arranged in the left (-x direction) side may be defined as the first-2 opening 102OP2, the first opening 102OP arranged in the upper (+y direction) side may be defined as the first-3 opening 102OP3, and the first opening 102OP arranged in the right (+x direction) side may be defined as the first-4 opening 102OP4.

The first openings 102OP of the second lower metal layer 102 may each have an approximately circular or oval shape in a plan view. In an embodiment, as shown in FIG. 12, the first openings 102OP may each have a shape in which two semi-circles are opened at a first angle θ1 in a plan view.

The second lower metal layer 102 may include the island portions ISL and the bridge portions BR. In an embodiment, for example, one island portion ISL and one bridge portion BR extending from the island portion ISL toward the non-transmissive area NTA may be arranged within each of the first openings 102OP of the second lower metal layer 102.

The island portions ISL may each have an approximately circular or oval shape in a plan view. In an embodiment, as shown in FIG. 12, the island portions ISL may each have a shape in which two semi-circles are opened at a second angle θ2 in a plan view.

The bridge portions BR may each have an approximately arc shape in a plan view. In an embodiment, for example, the bridge portion BR may have an arc shape extending along a portion of an imaginary circle VR. As illustrated in FIG. 12, the bridge portions BR may each have a first boundary and a second boundary, which are opposite each to other, and the first boundary may have a first radius r1 of curvature and the second boundary may have a second radius r2 of curvature. In other words, the first boundary of the bridge portion BR may extend along a portion of an imaginary first circle R1 having the first radius r1 of curvature, and the second boundary may extend along a portion of an imaginary second circle R2 having the second radius r2 of curvature. Although FIG. 12 illustrates an embodiment where the imaginary first circle R1 and the imaginary second circle R2 are concentric circles, the disclosure is not limited thereto. The center of the imaginary first circle R1 and the center of the imaginary second circle R2 may be apart from each other.

In an embodiment, as illustrated in FIG. 11A, the bridge portions BR respectively arranged in the first-1 opening 102OP1, the first-2 opening 102OP2, the first-3 opening 102OP3, and the first-4 opening 102OP4 may each have a same shape as each other, in a plan view.

In another embodiment, as illustrated in FIG. 11B, the bridge portions BR arranged in the first-1 opening 102OP1, the first-2 opening 102OP2, the first-3 opening 102OP3, and the first-4 opening 102OP4 may each have a shape of a corresponding one of four arcs dividing the imaginary circle VR into quarters. In an embodiment, for example, the bridge portion BR arranged in the first-1 opening 102OP1 may have a shape corresponding to the arc of the first quadrant of the imaginary circle VR, the bridge portion BR arranged in the first-2 opening 102OP2 may have a shape corresponding to the arc of the second quadrant of the imaginary circle VR, the bridge portion BR arranged in the first-3 opening 102OP3 may have a shape corresponding to the arc of the third quadrant of the imaginary circle VR, and the bridge portion BR arranged in the first-4 opening 102OP4 may have a shape corresponding to the arc of the fourth quadrant of the imaginary circle VR. An approximately circular shape may be obtained by connecting the bridge portions BR arranged in the first-1 opening 102OP1, the first-2 opening 102OP2, the first-3 opening 102OP3, and the first-4 opening 102OP4. In such an embodiment, by arranging the shapes of the bridge portions BR to be rotated according to a certain cycle, the diffraction of light transmitting through the transmissive area TA may be substantially reduced.

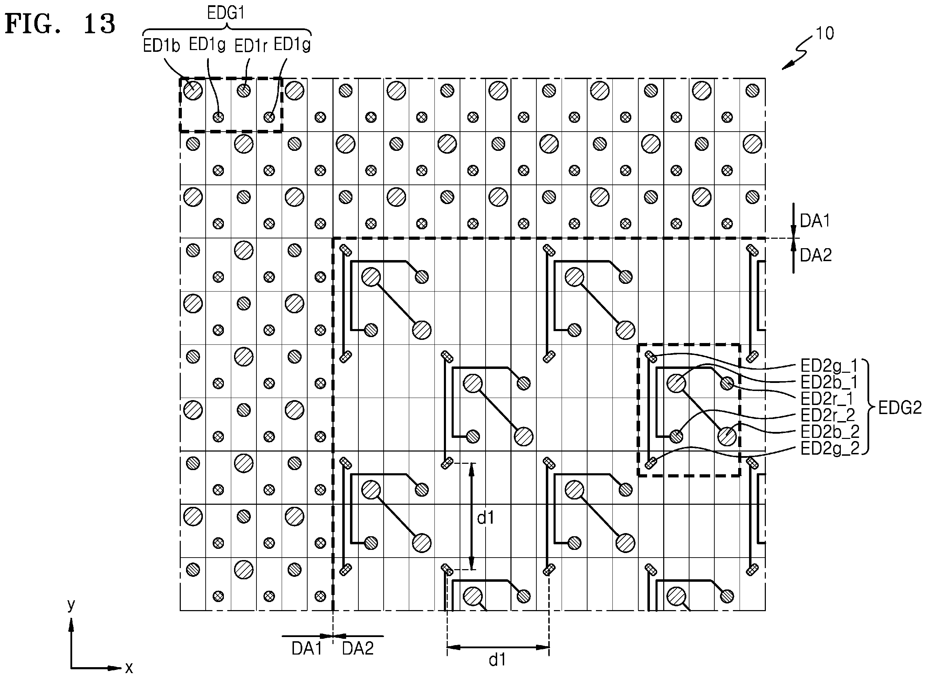

FIG. 13 is a schematic plan view of the display panel 10 according to an embodiment.

Referring to FIG. 13, an embodiment of the display panel 10 may include the first display area DA1 and the second display area DA2. In the first display area DA1, the first light-emitting diode groups EDG1 may be repeatedly arranged in the first direction (x direction) and the second direction (y direction). The first light-emitting diode groups EDG1 may be repeated units of the first light-emitting diodes ED1 described with reference to FIG. 5. The first light-emitting diode groups EDG1 may include one first red light-emitting diode ED1r, one first blue light-emitting diode ED1b, and two first green light-emitting diodes ED1g. The first red light-emitting diode ED1r, the first blue light-emitting diode ED1b, and the first green light-emitting diode ED1g may respectively emit red, blue, and green light.

In the first display area DA1, the first blue light-emitting diodes ED1b, the first red light-emitting diodes ED1r, and the first green light-emitting diodes ED1g may be arranged in the first direction (x direction) and the second direction (y direction) to form a matrix. The first blue light-emitting diode ED1b and the first red light-emitting diode ED1r may be alternately arranged in odd-numbered rows, and the first green light-emitting diodes ED1g may be repeatedly arranged in even-numbered rows. The first blue light-emitting diode ED1b and the first red light-emitting diode ED1r may be alternately arranged in odd-numbered columns, and the first green light-emitting diodes ED1g may be repeatedly arranged in even-numbered columns. In other words, in the first display area DA1, the first blue light-emitting diodes ED1b, the first red light-emitting diodes ED1r, and the first green light-emitting diodes ED1g may be arranged in a PenTile^{®} structure. The size (or area) of the first green light-emitting diode ED1g may be less than the size (or area) of the first red light-emitting diode ED1r and the size (or area) of the first blue light-emitting diode ED1b.

In the second display area DA2, the second light-emitting diode groups EDG2 may be repeatedly arranged in the first direction (x direction) and the second direction (y direction). The second light-emitting diode group EDG2 may be a repeated unit of the second light-emitting diodes ED2 described with reference to FIG. 5. The second light-emitting diode groups EDG2 may be arranged in the non-transmissive area NTA (see FIG. 5) of the second display area DA2 (see FIG. 2). One transmissive area TA (see FIG. 5) may be arranged between the second light-emitting diode groups EDG2 neighboring in the first direction (x direction). In other words, the second light-emitting diode groups EDG2 and the transmissive areas TA may be alternately arranged in the first direction (x direction). In such an embodiment, one transmissive area TA may be arranged between the second light-emitting diode groups EDG2 neighboring in the second direction (y direction). In other words, the second light-emitting diode groups EDG2 and the transmissive areas TA may be alternately arranged in the second direction (y direction).

The second light-emitting diode group EDG2 may include the second-1 blue light-emitting diode ED2b_1, the second-2 blue light-emitting diode ED2b_2, the second-1 red light-emitting diode ED2r_1, the second-2 red light-emitting diode ED2r_2, the second-1 green light-emitting diode ED2g_1, and the second-2 green light-emitting diode ED2g_2. The second-1 blue light-emitting diode ED2b_1 and the second-2 blue light-emitting diode ED2b_2 may be electrically connected to the same sub-pixel circuit via the connection wire. The second-1 red light-emitting diode ED2r_1 and the second-2 red light-emitting diode ED2r_2 may be electrically connected to the same sub-pixel circuit via the connection wire. The second-1 green light-emitting diode ED2g_1 and the second-2 green light-emitting diode ED2g_2 may be electrically connected to a same sub-pixel circuit via the connection wire. By connecting light-emitting diodes emitting light of the same color to one sub-pixel circuit, the area of the non-transmissive area NTA may be reduced in the second display area DA2. Accordingly, while the resolution of the second display area DA2 is improved, the transmittance of light or sound may be maintained or improved.

The second-1 green light-emitting diodes ED2g_1 and the second-2 green light-emitting diodes ED2g_2 may be arranged in the first direction (x direction) and the second direction (y direction) apart from each other at equal intervals. The second-1 green light-emitting diodes ED2g_1 and the second-2 green light-emitting diodes ED2g_2 neighboring in the first direction (x direction) may be apart from each other by the first distance d1, and the second-1 green light-emitting diodes ED2g_1 and the second-2 green light-emitting diodes ED2g_2 arranged in different second light-emitting diode groups EDG2 neighboring in the second direction (y direction) may be apart from each other by the first distance d1.

In an embodiment, the size (or area) of each of the second-1 red light-emitting diode ED2r_1 and the second-2 red light-emitting diode ED2r_2 may be equal to or greater than the size (or area) of the first red light-emitting diode ED1r. The size (or area) of each of the second-1 blue light-emitting diode ED2b_1 and the second-2 blue light-emitting diode ED2b_2 may be equal to or greater than the size (or area) of the first blue light-emitting diode ED1b. The size (or area) of each of the second-1 green light-emitting diode ED2g_1 and the second-2 green light-emitting diode ED2g_2 may be equal to or greater than the size (or area) of the first green light-emitting diode ED1g.

As the second display area DA2 includes the transmissive areas TA (see FIG. 1), the resolution of the second display area DA2 may be less than the resolution of the first display area DA1. According to the embodiments, as two or more second light-emitting diodes ED2 are electrically connected to the same sub-pixel circuit, the resolution of the second display area DA2 may be improved. In an embodiment, for example, the number of light-emitting diodes per unit area in the second display area DA2 may be 6/16 of the number of light-emitting diodes per unit area in the first display area DA1.

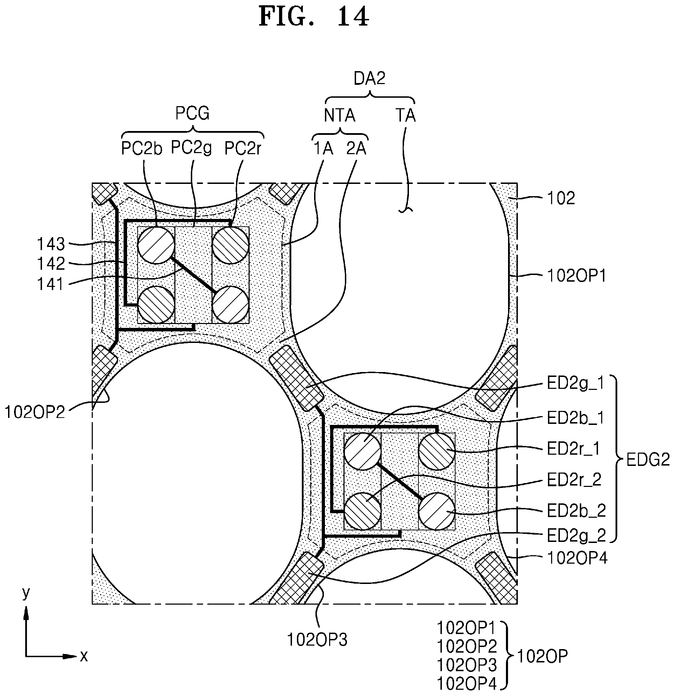

FIG. 14 is a schematic plan view of the display panel 10 according to an embodiment. FIG. 14 is a view showing the arrangement of the second light-emitting diode group EDG2 illustrated in FIG. 13.

Referring to FIG. 14, in an embodiment, the second display area DA2 may include the transmissive areas TA and the non-transmissive area NTA outside the transmissive areas TA. The non-transmissive area NTA may include the first areas 1A in which the sub-pixel circuit groups PCG are arranged and the second area 2A outside the first areas 1A. One first area 1A may be surrounded by the four transmissive areas TA.

The second lower metal layer 102 is arranged in the second display area DA2, and the second lower metal layer 102 may define the first openings 102OP overlapping the transmissive areas TA, respectively. The first openings 102OP of the second lower metal layer 102 may each have a circular shape in a plan view. Alternatively, the first openings 102OP of the second lower metal layer 102 may each have an oval shape or a capsule shape in a plan view. A portion of the boundary of each of the first openings 102OP of the second lower metal layer 102 may include the protruding portions PP (see FIG. 7B).

The sub-pixel circuit groups PCG may each be arranged in the first area 1A of the non-transmissive area NTA. The sub-pixel circuit groups PCG may each include the second blue sub-pixel circuit PC2b, the second red sub-pixel circuit PC2r, and the second green sub-pixel circuit PC2g.

The second light-emitting diode groups EDG2 may each be arranged in the non-transmissive area NTA. The second light-emitting diode groups EDG2 may each include the second-1 blue light-emitting diode ED2b_1, the second-2 blue light-emitting diode ED2b_2, the second-1 red light-emitting diode ED2r_1, the second-2 red light-emitting diode ED2r_2, the second-1 green light-emitting diode ED2g_1, and the second-2 green light-emitting diode ED2g_2. The second light-emitting diode groups EDG2 may each include second-1 light-emitting diodes arranged in the first area 1A and second-2 light-emitting diodes arranged in the second area 2A.

In an embodiment, for example, the second-1 blue light-emitting diode ED2b_1, the second-2 blue light-emitting diode ED2b_2, the second-1 red light-emitting diode ED2r_1, and the second-2 red light-emitting diode ED2r_2 may be defined as the second-1 light-emitting diodes arranged in the first area 1A, and the second-1 green light-emitting diode ED2g_1 and the second-2 green light-emitting diode ED2g_2 may be defined as the second-2 light-emitting diodes arranged in the second area 2A. In an embodiment, the second-1 blue light-emitting diode ED2b_1, the second-2 blue light-emitting diode ED2b_2, the second-1 red light-emitting diode ED2r_1, and the second-2 red light-emitting diode ED2r_2 may be arranged to overlap the sub-pixel circuit group PCG, and the second-1 green light-emitting diode ED2g_1 and the second-2 green light-emitting diode ED2g_2 may be arranged apart from the sub-pixel circuit group PCG.

The second-1 blue light-emitting diode ED2b_1 and the second-2 blue light-emitting diode ED2b_2 may be electrically connected to the second blue sub-pixel circuit PC2b. The second-2 blue light-emitting diode ED2b_2 may be arranged apart from the second blue sub-pixel circuit PC2b but electrically connected to the second blue sub-pixel circuit PC2b via a first connection wire 141. The second-1 red light-emitting diode ED2r_1 and the second-2 red light-emitting diode ED2r_2 may be electrically connected to the second red sub-pixel circuit PC2r. The second-2 red light-emitting diode ED2r_2 may be arranged apart from the second red sub-pixel circuit PC2r but electrically connected to the second red sub-pixel circuit PC2r via a second connection wire 142.

In an embodiment, the first areas 1A of the non-transmissive area NTA may each be surrounded by the four transmissive areas TA in a plan view. The second-2 light-emitting diodes may be arranged in the second area 2A of the non-transmissive area NTA, and each of the second-2 light-emitting diodes may be arranged between two adjacent transmissive areas TA among the four transmissive areas TA.

In an embodiment, for example, the second lower metal layer 102 may include the first-1 opening 102OP1 arranged in the upper (+y direction) side of the first area 1A, the first-2 opening 102OP2 arranged in the left (-x direction) side of the first area 1A, the first-3 opening 102OP3 arranged in the lower (-y direction) side of the first area 1A, and the first-4 opening 102OP4 arranged in the right (+x direction) side of the first area 1A. The second-1 green light-emitting diode ED2g_1 may be arranged between the first-1 opening 102OP1 of the second lower metal layer 102 and the first-2 opening 102OP2 of the second lower metal layer 102. The second-2 green light-emitting diode ED2g_2 may be arranged between the first-2 opening 102OP2 of the second lower metal layer 102 and the first-3 opening 102OP3 of the second lower metal layer 102. Accordingly, one transmissive area TA (or the first opening 102OP) may be surrounded by four second-2 light-emitting diodes.

The second-1 green light-emitting diode ED2g_1 and the second-2 green light-emitting diode ED2g_2 may be electrically connected to the second green sub-pixel circuit PC2g. The second-1 green light-emitting diode ED2g_1 and the second-2 green light-emitting diode ED2g_2 may be arranged apart from the sub-pixel circuit group PCG but electrically connected to the second green sub-pixel circuit PC2g via a third connection wire 143.

In an embodiment, the second-1 blue light-emitting diode ED2b_1, the second-2 blue light-emitting diode ED2b_2, the second-1 red light-emitting diode ED2r_1 and the second-2 red light-emitting diode ED2r_2 may each have a circular shape in a plan view. The second-1 green light-emitting diode ED2g_1 and the second-2 green light-emitting diode ED2g_2 may each have a rectangular shape, in a plan view, that is lengthy in a direction intersecting the first direction (x direction) and the second direction (y direction). However, the disclosure is not limited thereto, and the second-1 blue light-emitting diode ED2b_1, the second-2 blue light-emitting diode ED2b_2, the second-1 red light-emitting diode ED2r_1, the second-2 red light-emitting diode ED2r_2, the second-1 green light-emitting diode ED2g_1, and the second-2 green light-emitting diode ED2g_2 may each have various shape, such as oval, polygonal, or amorphous in a plan view.

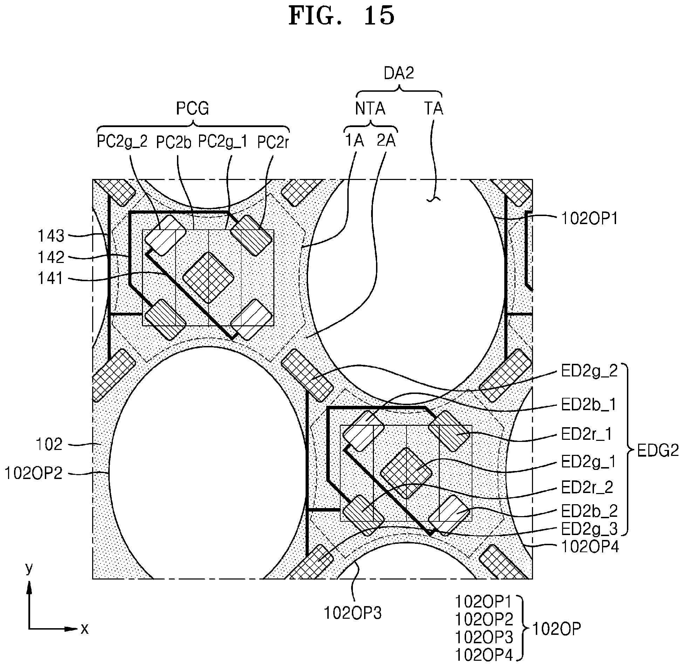

FIG. 15 is a schematic plan view of the display panel 10 according to an embodiment.

The display panel 10 shown in FIG. 15 is substantially the same as the display panel 10 shown in FIG. 14 except that the sub-pixel circuit group PCG further includes the second blue sub-pixel circuit PC2b, the second red sub-pixel circuit PC2r, a second-1 green sub-pixel circuit PC2g_1, and the second-2 green sub-pixel circuit PC2g_2, and the second light-emitting diode group EDG2 further includes the second-1 green light-emitting diode ED2g_1 arranged in the first area 1A. Any repetitive detailed descriptions of the same or similar components as those described above are omitted, and differences are mainly described below.

Referring to FIG. 15, in an embodiment, the sub-pixel circuit groups PCG may each be arranged in the first area 1A of the non-transmissive area NTA. The sub-pixel circuit groups PCG may each include the second blue sub-pixel circuit PC2b, the second red sub-pixel circuit PC2r, the second-1 green sub-pixel circuit PC2g_1, and the second-2 green sub-pixel circuit PC2g_2.

The second light-emitting diode groups EDG2 may each be arranged in the non-transmissive area NTA. The second light-emitting diode groups EDG2 may each include the second-1 blue light-emitting diode ED2b_1, the second-2 blue light-emitting diode ED2b_2, the second-1 red light-emitting diode ED2r_1, the second-2 red light-emitting diode ED2r_2, the second-1 green light-emitting diode ED2g_1, the second-2 green light-emitting diode ED2g_2, and the second-3 green light-emitting diode ED2g_3. The second light-emitting diode groups EDG2 may each include the second-1 light-emitting diodes arranged in the first area 1A and the second-2 light-emitting diodes arranged in the second area 2A.

In an embodiment, for example, the second-1 blue light-emitting diode ED2b_1, the second-2 blue light-emitting diode ED2b_2, the second-1 red light-emitting diode ED2r_1, the second-2 red light-emitting diode ED2r_2, and the second-1 green light-emitting diode ED2g_1 may be defined as the second-1 light-emitting diodes arranged in the first area 1A, and the second-2 green light-emitting diode ED2g_2 and the second-3 green light-emitting diode ED2g_3 may be defined as the second-2 light-emitting diodes arranged in the second area 2A. In an embodiment, the second-1 blue light-emitting diode ED2b_1, the second-2 blue light-emitting diode ED2b_2, the second-1 red light-emitting diode ED2r_1, the second-2 red light-emitting diode ED2r_2, and the second-1 green light-emitting diode ED2g_1 may be arranged to overlap the sub-pixel circuit group PCG, and the second-2 green light-emitting diode ED2g_2 and the second-3 green light-emitting diode ED2g_3 may be arranged apart from the sub-pixel circuit group PCG.

The second-1 blue light-emitting diode ED2b_1 and the second-2 blue light-emitting diode ED2b_2 may be electrically connected to the second blue sub-pixel circuit PC2b. The second-2 blue light-emitting diode ED2b_2 may be arranged apart from the second blue sub-pixel circuit PC2b but electrically connected to the second blue sub-pixel circuit PC2b via the first connection wire 141. The second-1 red light-emitting diode ED2r_1 and the second-2 red light-emitting diode ED2r_2 may be electrically connected to the second red sub-pixel circuit PC2r. The second-2 red light-emitting diode ED2r_2 may be arranged apart from the second red sub-pixel circuit PC2r but electrically connected to the second red sub-pixel circuit PC2r via the second connection wire 142. The second-1 green light-emitting diode ED2g_1 may be electrically connected to the second-1 green sub-pixel circuit PC2g_1.

The second-1 green light-emitting diode ED2g_1 may be arranged approximately in the center area of the first area 1A. The second-1 red light-emitting diode ED2r_1 and the second-2 red light-emitting diode ED2r_2 may be arranged at first and third vertices facing each other among four vertices of an imaginary quadrangle having the second-1 green light-emitting diode ED2g_1 as a center, and the second-1 blue light-emitting diode ED2b_1 and the second-2 blue light-emitting diode ED2b_2 may be arranged at second and fourth vertices. In an embodiment, for example, the second-1 light-emitting diodes may be arranged approximately in a PenTile^{®} structure.

In an embodiment, the first areas 1A of the non-transmissive area NTA may each be surrounded by the four transmissive areas TA in a plan view. The second-2 light-emitting diodes may be arranged in the second area 2A of the non-transmissive area NTA, and each of the second-2 light-emitting diodes may be arranged between two adjacent transmissive areas TA among the four transmissive areas TA.

In an embodiment, for example, the second lower metal layer 102 may include the first-1 opening 102OP1 arranged in the upper (+y direction) side of the first area 1A, the first-2 opening 102OP2 arranged in the left (-x direction) side of the first area 1A, the first-3 opening 102OP3 arranged in the lower (-y direction) side of the first area 1A, and the first-4 opening 102OP4 arranged in the right (+x direction) side of the first area 1A. The second-2 green light-emitting diode ED2g_2 may be arranged between the first-1 opening 102OP1 of the second lower metal layer 102 and the first-2 opening 102OP2 of the second lower metal layer 102. The second-3 green light-emitting diode ED2g_3 may be arranged between the first-2 opening 102OP2 of the second lower metal layer 102 and the first-3 opening 102OP3. Accordingly, one transmissive area TA (or the first opening 102OP) may be surrounded by four second-2 light-emitting diodes.

The second-2 green light-emitting diode ED2g_2 and the second-3 green light-emitting diode ED2g_3 may be electrically connected to the second-2 green sub-pixel circuit PC2g_2. The second-2 green light-emitting diode ED2g_2 and the second-3 green light-emitting diode ED2g_3 may be arranged apart from the sub-pixel circuit group PCG but electrically connected to the second green sub-pixel circuit PC2g via the third connection wire 143.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the appended claims.

## Claims

1. A display panel (10) comprising:
a substrate (100) comprising a first display area (DA1) and a second display area (DA2) surrounded by the first display area (DA1), wherein the second display (DA2) area comprises a transmissive area (TA) and a non-transmissive area (NTA);
a first sub-pixel circuit group disposed in the first display area (DA1);
a first light-emitting diode group (EDG1) disposed in the first display area (DA1) and electrically connected to the first sub-pixel circuit group;
a second sub-pixel circuit group (PCG) disposed in the non-transmissive area (NTA);
a second light-emitting diode group (EDG2) disposed in the non-transmissive area (NTA) and electrically connected to the second sub-pixel circuit group (PCG); and
an auxiliary light-emitting diode (EDa) disposed inside the transmissive area (TA) and electrically connected to the second sub-pixel circuit group (PCG).

2. The display panel (10) of claim 1, further comprising a lower metal layer (102) disposed in the second display area (DA2) and defining a first opening (102OP) overlapping the transmissive area (TA),
wherein the lower metal layer (102) comprises a first island portion (ISL) overlapping the auxiliary light-emitting diode (EDa), and a bridge portion (BR) extending from the first island portion (ISL) to the non-transmissive area (NTA).

3. The display panel (10) of claim 2,
wherein the first opening (102OP) has an oval shape or a capsule shape, in a plan view, and
at least a portion of a boundary of the first opening (102OP) is convex; or
wherein the first opening (102OP) has a circular shape in a plan view, and
the auxiliary light-emitting diode (EDa) overlaps a center area of the first opening (102OP).

4. The display panel of claim 2 or 3,
wherein the bridge portion (BR) has an arc shape in a plan view; and/or
wherein the bridge portion (BR) has a first boundary and a second boundary, which are opposite to each other,
the first boundary has a first radius of curvature, and
the second boundary has a second radius of curvature greater than the first radius of curvature; and/or
wherein the bridge portion (BR) is provided in plural, and
a plurality of bridge portions (BR) has a same shape as each other in a plan view.

5. The display panel (10) of claim 4, wherein the first opening (102OP) is provided in plural,
a plurality of first openings (102OP) comprises a first first opening (102OP1), a second first opening (102OP2), a third first opening (102OP3), and a fourth first opening (102OP4), which surround one point of the non-transmissive area (NTA), and
a bridge portion (BR) of the first first opening (102OP1), a bridge portion (BR) of the second first opening (102OP2), a bridge portion (BR) of the third first opening (102OP3), and a bridge portion of the fourth first opening (102OP4) respectively have shapes of four arcs, which are obtained by dividing an imaginary circle into four quarters.

6. The display panel (10) of any one of the preceding claims, wherein the second light-emitting diode group (EDG2) and the auxiliary light-emitting diode (EDa) are alternately arranged in a first direction and a second direction intersecting the first direction.

7. The display panel (10) of any one of the preceding claims, wherein the first light-emitting diode group (EDG1) comprises a first red light-emitting diode (ED1r) and a first blue light-emitting diode (ED1b) arranged in an odd-numbered row, and a first green light-emitting diode (ED1g) arranged in an even-numbered row, and
the second light-emitting diode group (EDG2) comprises a second red light-emitting diode (ED2r) and a second blue light-emitting diode (ED2b) arranged in the odd-numbered row and a second green light-emitting diode (ED2g) arranged in the even-numbered row.

8. The display panel (10) of claim 7,
wherein the auxiliary light-emitting diode (EDa) is arranged in the even-numbered row; and/or
wherein the auxiliary light-emitting diode (EDa) emits green light; and/or
wherein the second green light-emitting diode (ED2g) and the auxiliary light-emitting diode (EDa) are alternately arranged in a first direction and a second direction intersecting the first direction, and are spaced apart from each other at equal intervals.

9. The display panel (10) of any one of claims 1 to 8, further comprising:
an encapsulation layer (300) disposed on the first light-emitting diode group (EDG1), the second light-emitting diode group (EDG2), and the auxiliary light-emitting diode (EDa);
a light shielding layer (410) disposed on the encapsulation layer (300) and defining first filter openings (OP3) overlapping the second light-emitting diode group (EDG2) and a second opening (410OP) overlapping the transmissive area (TA);
first color filters (421) disposed on the light shielding layer (410) to correspond to the second light-emitting diode group (EDG2); and
a second color filter (423) disposed on the encapsulation layer (300) to correspond to the auxiliary light-emitting diode (EDa).

10. The display panel (10) of claim 9, wherein the light shielding layer (410) further comprises a first portion (410P) disposed within the second opening (410OP), and
the first portion (410P) defines the second filter opening (OP3') overlapping the auxiliary light-emitting diode (EDa).

11. The display panel (10) of any one of claims 1 to 8, further comprising:
an encapsulation layer (300) disposed on the first light-emitting diode group (EDG1), the second light-emitting diode group (EDG2), and the auxiliary light-emitting diode (EDa);
a light shielding layer (410) disposed on the encapsulation layer (300) and defining first filter openings (OP3) overlapping the second light-emitting diode group (EDG2) and a second filter opening (OP3') overlapping the auxiliary light-emitting diode (EDa);
first color filters (421) disposed on the light shielding layer (410) to correspond to the second light-emitting diode group (EDG2); and
a second color filter (423) disposed on the light shielding layer (410) to correspond to the auxiliary light-emitting diode (EDa).

12. The display panel (10) of any one of the preceding claims, further comprising an insulating layer (117, 118) between the second sub-pixel circuit group (PCG) and the second light-emitting diode group (EDG2),
wherein the insulating layer (117, 118) defines an opening (117OP, 118OP) overlapping the transmissive area (TA).

13. The display panel (10) of any one of the preceding claims, wherein the non-transmissive area (NTA) comprises a first area (1A) and a second area (2A) outside the first area (1A),
the second sub-pixel circuit group (PCG) is disposed in the first area (1A), and
the second light-emitting diode group (EDG2) comprises second red light-emitting diodes (ED2r) and second blue light-emitting diodes (ED2b) disposed in the first area (1A), and third green light-emitting diodes (ED2g_2, ED2g_3) disposed in the second area (2A).

14. The display panel (10) of claim 13, wherein the second light-emitting diode group (EDG2) further comprises a second green light-emitting diode (ED2g_1) arranged in the first area (1A), and
the third green light-emitting diode (ED2g_1) and the second green light-emitting diodes (ED2g_2, ED2g_3) are electrically connected to a same sub-pixel circuit.

15. A display panel (10) comprising:
a substrate (100) comprising a first display area (DA1) and a second display area (DA2) defined inside the first display area (DA1), wherein the second display area (DA2) comprises a transmissive area (TA) and a non-transmissive area (NTA) outside the transmissive area (TA);
a first sub-pixel circuit group disposed in the first display area (DA1);
a first light-emitting diode group (EDG1) disposed in the first display area (DA1) and electrically connected to the first sub-pixel circuit group;
a second sub-pixel circuit group (PCG) disposed in the non-transmissive area (NTA); and
a second light-emitting diode group (EDG2) disposed in the non-transmissive area (NTA) and electrically connected to the second sub-pixel circuit group (PCG),
wherein the non-transmissive area (NTA) comprises a first area (1A) and a second area (2A) outside the first area (1A),
the second sub-pixel circuit group (PCG) is disposed in the first area (1A), and
the second light-emitting diode group (EDG2) comprises first second light-emitting diodes disposed in the first area (1A) and second second light-emitting diodes disposed in the second area (2A).

16. The display panel (10) of claim 15, wherein the transmissive area (TA) is provided in plural,
the first area (1A) is surrounded by four transmissive areas (TA) in a plan view, and
each of the second second light-emitting diodes is disposed between two adjacent transmissive areas (TA) among the four transmissive areas (TA).

17. The display panel (10) of claim 15 or 16,
wherein the first second light-emitting diodes comprise at least one blue light-emitting diode (ED2b_1, ED2b_2) and at least one red light-emitting diode (ED2r_1, ED2r_2), and
the second second light-emitting diodes comprise green light-emitting diodes (ED2g_1, ED2g_2); or
wherein the first second light-emitting diodes comprise at least one blue light-emitting diode (ED2b_1, ED2b_2), at least one red light-emitting diode (ED2r_1, ED2r_2), and a single green light-emitting diode (ED2g_1), and
the second second light-emitting diodes comprise green light-emitting diodes (ED2g_2, ED2g_3).

18. The display panel of any one of claims claim 15 to 17, wherein a pair of the second second light-emitting diodes adjacent to each other are electrically connected to a same sub-pixel circuit (PCG).

19. The display panel (10) of any one of claims 15 to 18, further comprising:
a lower metal layer (102) arranged in the second display area (DA2) and defining a first opening (102OP) overlapping the transmissive area (TA),
wherein the first opening (102OP) has an oval shape or a capsule shape, in a plan view;
wherein at least a portion of a boundary of the first opening (102OP) is optionally convex.

20. An electronic apparatus (1) comprising:
a display panel (10) according to any one of the preceding claims; and
a component (40) overlapping the display panel (10).
